# EUROPEAN PATENT APPLICATION

(11) **EP 4 456 699 A1**
(43) Date of publication of application: **30.10.2024**
(21) Application number: 24171708.1
(22) Date of filing: 22.04.2024
(51) Int. Cl.: H10K 59/122, H10K 59/80

(54) **DISPLAY PANEL, DISPLAY DEVICE, AND METHOD FOR MANUFACTURING DISPLAY PANEL**

(30) Priority: 28.04.2023 KR 20230056208
(71) Applicant: Samsung Display Co., Ltd., Gyeonggi-do (KR)
(72) Inventor: SHIN, Hyuneok, Yongin-si (KR); LEE, Juhyun, Yongin-si (KR)
(74) Representative: Marks & Clerk LLP

(57) **Abstract**

A display panel includes a base layer, a pixel defining film which is disposed on the base layer and in which a light-emitting opening is defined, a partition wall which is disposed on the pixel defining film and in which a partition wall opening corresponding to the light-emitting opening is defined, a low reflection layer disposed on the partition wall and including a light absorbing material, and a light-emitting element overlapping the partition wall opening and including an anode, an intermediate layer, and a cathode electrically connected to the partition wall.

## Description

### BACKGROUND

### 1. Field

Embodiments of the disclosure described herein relate to a display panel, a display device including the display panel, and a method for manufacturing the display panel, and more particularly, relate to a display panel with improved display quality, a display device including the display panel, and a method for manufacturing the display panel.

### 2. Description of the Related Art

A display device such as a television, a monitor, a smart phone, and a tablet that provides an image to a user includes a display panel that displays the image. As the display panel, various display panels such as a liquid crystal display panel, an organic light-emitting display panel, an electro wetting display panel, and an electrophoretic display panel are being developed.

The organic light-emitting display panel may include an anode, a cathode, and a light-emitting pattern. The light-emitting pattern may be separated for each light-emitting area, and a cathode may provide a common voltage to the light-emitting areas.

### SUMMARY

Embodiments of the disclosure provide a display panel with improved display quality that forms a light-emitting element without using a metal mask, a display device including the display panel, and a method for manufacturing the display panel.

In an embodiment of the disclosure, a display panel includes a base layer, a pixel defining film disposed on the base layer, wherein a light-emitting opening is defined in the pixel defining film, a partition wall disposed on the pixel defining film, wherein a partition wall opening corresponding to the light-emitting opening is defined in the partition wall, a low reflection layer disposed on the partition wall and including a light absorbing material, and a light-emitting element including an anode, an intermediate layer, and a cathode electrically connected to the partition wall, and overlapping the partition wall opening.

In an embodiment, the display panel may further include a thin film encapsulation layer covering the partition wall and the light-emitting element, the low reflection layer may contact a portion of the thin film encapsulation layer.

In an embodiment, the low reflection layer may include amorphous silicon (a-Si).

In an embodiment, the low reflection layer may include silicon carbide (SiC).

In an embodiment, the low reflection layer may include molybdenum oxide (MoOₓ).

In an embodiment, a thickness of the low reflection layer may be equal to or greater than about 30 angstroms and equal to or smaller than about 150 angstroms.

In an embodiment, a thickness of the low reflection layer may be equal to or greater than about 200 angstroms and equal to or smaller than about 500 angstroms.

In an embodiment, the partition wall may include a first partition wall layer disposed on the pixel defining film and defining a first area of the partition wall opening, and a second partition wall layer disposed on the first partition wall layer and defining a second area of the partition wall opening.

In an embodiment, the low reflection layer may include an inner surface of the low reflection layer defining a first opening overlapping the partition wall opening, and the inner surface of the low reflection layer may be aligned with an inner surface of the second partition wall layer.

In an embodiment of the disclosure, a display device includes a display panel, and an anti-reflection layer disposed on the display panel and including a light-blocking pattern. The display panel includes a base layer, a pixel defining film disposed on the base layer, wherein a light-emitting opening is defined in the pixel defining film, a partition wall disposed on the pixel defining film, wherein a partition wall opening corresponding to the light-emitting opening is defined in the partition wall, a low reflection layer disposed on the partition wall and including a light absorbing material, and a light-emitting element including an anode, an intermediate layer, and a cathode electrically connected to the partition wall, and overlapping the partition wall opening.

In an embodiment, the display panel may further include a thin film encapsulation layer covering the partition wall and the light-emitting element, and the low reflection layer may contact a portion of the thin film encapsulation layer.

In an embodiment, the low reflection layer may include amorphous silicon (a-Si).

In an embodiment, the low reflection layer may include silicon carbide (SiC).

In an embodiment, the low reflection layer may include molybdenum oxide (MoOₓ).

In an embodiment, a thickness of the low reflection layer may be equal to or greater than about 30 angstroms and equal to or smaller than about 150 angstroms.

In an embodiment, a thickness of the low reflection layer may be equal to or greater than about 200 angstroms and equal to or smaller than about 500 angstroms.

In an embodiment, the partition wall may include a first partition wall layer disposed on the pixel defining film and defining a first area of the partition wall opening, and a second partition wall layer disposed on the first partition wall layer and defining a second area of the partition wall opening, and the low reflection layer may include an inner surface of the low reflection layer defining a first opening overlapping the partition wall opening, and the inner surface of the low reflection layer may be aligned with an inner surface of the second partition wall layer.

In an embodiment of the disclosure, a method for manufacturing a display panel includes providing a preliminary display panel including a base layer, a pixel defining film disposed on the base layer, and a preliminary partition wall disposed on the pixel defining film, forming a preliminary low reflection layer including a light absorbing material on the preliminary partition wall, forming a low reflection layer with a first opening defined by etching the preliminary low reflection layer, forming a partition wall with a partition wall opening defined by etching the preliminary partition wall, and forming a light-emitting element including a light-emitting pattern and a cathode electrically connected to the partition wall within the partition wall opening.

In an embodiment, the forming the preliminary low reflection layer may include performing chemical vapor deposition of a material including amorphous silicon (a-Si) or silicon carbide (SiC).

In an embodiment, the forming the preliminary low reflection layer may include sputtering a material including molybdenum oxide (MoOₓ).

At least some of the above and other features of the invention are set out in the claims.

### BRIEF DESCRIPTION OF THE DRAWINGS

The above and other embodiments, advantages and features of the disclosure will become apparent by describing in detail embodiments thereof with reference to the accompanying drawings.
FIG. 1A is a perspective view of an embodiment of a display device according to the disclosure.
FIG. 1B is an exploded perspective view of an embodiment of a display device according to the disclosure.
FIG. 2A is a cross-sectional view of an embodiment of a display device according to the disclosure.
FIG. 2B is a cross-sectional view of an embodiment of a display device according to the disclosure.
FIG. 3 is a plan view of an embodiment of a display panel according to the disclosure.
FIG. 4 is an equivalent circuit diagram of an embodiment of a pixel according to the disclosure.
FIG. 5 is an enlarged plan view of an embodiment of a portion of a display area of a display panel according to the disclosure.
FIG. 6 is a cross-sectional view of an embodiment of a display panel according to the disclosure taken along line I-I' in FIG. 3.
FIG. 7 shows reflectance graphs of an embodiment of a low reflection layer according to the disclosure.
FIG. 8 is a cross-sectional view of an embodiment of a display panel according to the disclosure taken along line II-II' in FIG. 5.
FIGS. 9A to 9I are cross-sectional views showing an embodiment of some of steps of a method for manufacturing a display panel according to the disclosure.

### DETAILED DESCRIPTION

In the document, when a component (or an area, a layer, a portion, and the like) is referred to as being "on", "connected to", or "coupled to" another component, it means that the component may be directly disposed/connected/coupled on another component or a third component may be disposed between the component and another component.

Like reference numerals refer to like components. In addition, in the drawings, thicknesses, ratios, and dimensions of components are exaggerated for effective description of technical content. "and/or" includes all of one or more combinations that the associated components may define.

Terms such as first, second, and the like may be used to describe various components, but the components should not be limited by the terms. The above terms are used only for the purpose of distinguishing one component from another. For example, without departing from the scope of the disclosure, a first component may be named as a second component, and similarly, the second component may also be named as the first component. The singular expression includes the plural expression unless the context clearly dictates otherwise.

In addition, terms such as "beneath", "below", "on", "above" are used to describe the relationship of the components shown in the drawings. The above terms are relative concepts, and are described with reference to directions indicated in the drawings.

It should be understood that terms such as "include" or "have" are intended to specify that a feature, a number, a step, an operation, a component, a part, or any combinations thereof described in the specification is present, and do not preclude a possibility of addition or existence of one or more other features or numbers, steps, operations, components, parts, or combinations thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

Unless otherwise defined, all terms including technical and scientific terms used herein have the same meaning as commonly understood by one of ordinary skill in the art to which this disclosure belongs. Terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the disclosure will be described with reference to drawings.

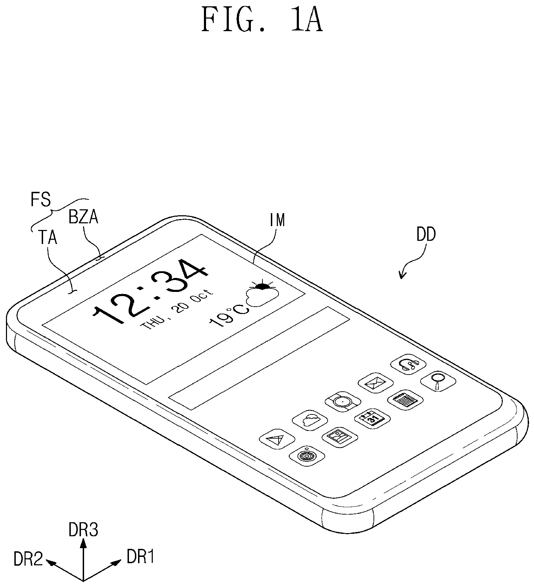

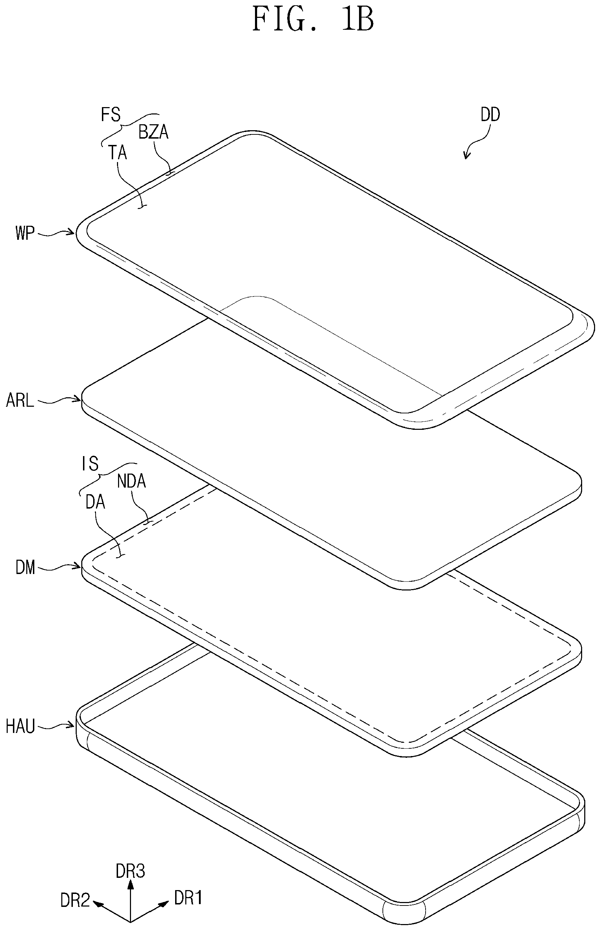

FIG. 1A is a perspective view of an embodiment of a display device according to the disclosure, and FIG. 1B is an exploded perspective view of an embodiment of a display device according to the disclosure.

In an embodiment, a display device DD may be a relatively large electronic device such as a television, a monitor, or an external billboard. In addition, the display device DD may be a relatively small or medium-sized electronic device such as a personal computer, a laptop computer, a personal digital terminal, a vehicle navigation unit, a game console, a smart phone, a tablet, and a camera. However, this is an illustrative embodiment, and the display device DD is able to be employed as another display device as long as it does not deviate from the concept of the disclosure. In FIGS. 1A and 1B, it is illustrated that the display device DD is the smart phone.

Referring to FIGS. 1A and 1B, the display device DD may display an image IM in a third direction DR3 on a display surface FS parallel to each of a first direction DR1 and a second direction DR2. The image IM may include a still image as well as a dynamic image. In FIG. 1A, a clock window and icons are shown in an embodiment of the image IM. The display surface FS on which the image IM is displayed may correspond to a front surface of the display device DD.

In the illustrated embodiment, a front surface (or a top surface) and a rear surface (or a bottom surface) of each member are defined based on the direction in which the image IM is displayed. The front surface and the rear surface may be opposite to each other in the third direction DR3, and a normal direction of each of the front surface and the rear surface may be parallel to the third direction DR3. In an embodiment, directions respectively indicated by the first to third directions DR1, DR2, and DR3 are relative concepts and are able to be converted into other directions. Herein, "a plan view" may mean a view in the third direction DR3.

The display device DD may include a window WP, an anti-reflection layer ARL, a display module DM, and a housing HAU. The window WP and the housing HAU may be coupled to each other to form an outer appearance of the display device DD.

The window WP may include or consist of an optically transparent insulating material. In an embodiment, the window WP may include or consist of glass or plastic, for example. A front surface of the window WP may define the display surface FS of the display device DD. The display surface FS may include a transmissive area TA and a bezel area BZA. The transmissive area TA may be an optically transparent area. In an embodiment, the transmissive area TA may have a visible light transmittance equal to or higher than about 90%, for example.

The bezel area BZA may be an area having a relatively low light transmittance compared to the transmissive area TA. The bezel area BZA may define a shape of the transmissive area TA. The bezel area BZA may be adjacent to the transmissive area TA and may surround the transmissive area TA. However, this is shown in an embodiment, and the bezel area BZA of the window WP may be omitted. The window WP may include at least one functional layer of an anti-fingerprint layer and a hard coating layer, and may not be limited to any particular embodiment.

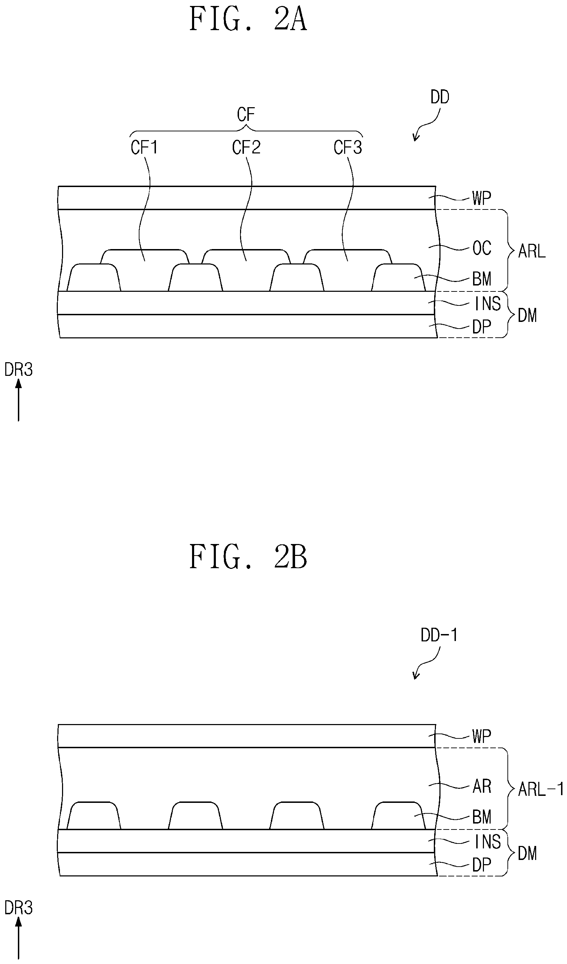

The anti-reflection layer ARL may be disposed beneath the window WP. The anti-reflection layer ARL may reduce a reflectance of external light. The anti-reflection layer ARL may include a light-blocking pattern BM (refer to FIG. 2A). The window WP and the anti-reflection layer ARL may be coupled to each other by an adhesive layer. The adhesive layer may be a pressure sensitive adhesive film ("PSA") or an optically clear adhesive ("OCA").

The display module DM may be disposed beneath the anti-reflection layer ARL. The display module DM may be a component that actually creates the image IM. The image IM generated by the display module DM is displayed on a display surface IS of the display module DM and viewed by a user from the outside via the transmissive area TA.

The display module DM may include a display area DA and a non-display area NDA. The display area DA may be an area activated in response to an electrical signal. The non-display area NDA may be adjacent to the display area DA. The non-display area NDA may surround the display area DA. The non-display area NDA, as an area covered by the bezel area BZA, may not be visible from the outside.

The housing HAU may be coupled to the window WP. The housing HAU may be coupled to the window WP to provide a predetermined internal space. The display module DM may be accommodated in the internal space.

The housing HAU may include or consist of a material with a relatively high rigidity. In an embodiment, the housing HAU may include a plurality of frames and/or plates including or consisting of glass, plastic, or metal, or any combinations thereof, for example. The housing HAU may stably protect components of the display device DD accommodated in the internal space from an external impact.

FIG. 2A is a cross-sectional view of an embodiment of a display device according to the disclosure. In the description of FIG. 2A, the description will be made with reference to FIG. 1B and descriptions of the same reference numerals will be omitted.

Referring to FIG. 2A, the display module DM may include a display panel DP and an input sensor INS. Although not separately shown, the display device DD in an embodiment of the disclosure may further include a protective member disposed on a bottom surface of the display panel DP.

The display panel DP may be a light-emitting display panel. However, this is merely one of the embodiments and the display panel DP is not particularly limited thereto. In an embodiment, the display panel DP may be an organic light-emitting display panel or an inorganic light-emitting display panel, for example. A light-emitting layer in the organic light-emitting display panel may include or consist of an organic light-emitting material. A light-emitting layer in the inorganic light-emitting display panel may include or consist of quantum dots, quantum rods, or micro LEDs. Hereinafter, the display panel DP is described as the organic light-emitting display panel.

The input sensor INS acquires coordinate information of an external input. The input sensor INS may have a multi-layer structure. The input sensor INS may include a single or multiple conductive layers. In addition, the input sensor INS may include a single or multiple insulating layers. The input sensor INS may sense the external input in a capacitive manner. However, this is an illustrative embodiment, and the disclosure is not limited thereto. In an embodiment, the input sensor INS may sense the external input using an electromagnetic induction scheme or a pressure sensing scheme, for example. In an embodiment, in another embodiment of the disclosure, the input sensor INS may be omitted.

The input sensor INS may be disposed directly on the display panel DP. Herein, "a component A is disposed directly on a component B" means that an adhesive layer is not disposed between the component A and the component B.

The anti-reflection layer ARL may include the light-blocking pattern BM, a color filter CF, and an overcoat layer OC. The anti-reflection layer ARL disposed on the display module DM may be a layer that does not include a polarization layer.

The light-blocking pattern BM may be disposed on the input sensor INS. The light-blocking pattern BM is a layer having a black color. In an embodiment, the light-blocking pattern BM may include or consist of a black coloring agent. The black coloring agent may include a black dye and a black pigment. The black coloring agent may include or consist of carbon black, metal such as chromium, or oxides thereof. However, this is an illustrative embodiment, and the material constituting the light-blocking pattern BM is not particularly limited as long as it is a material that absorbs light.

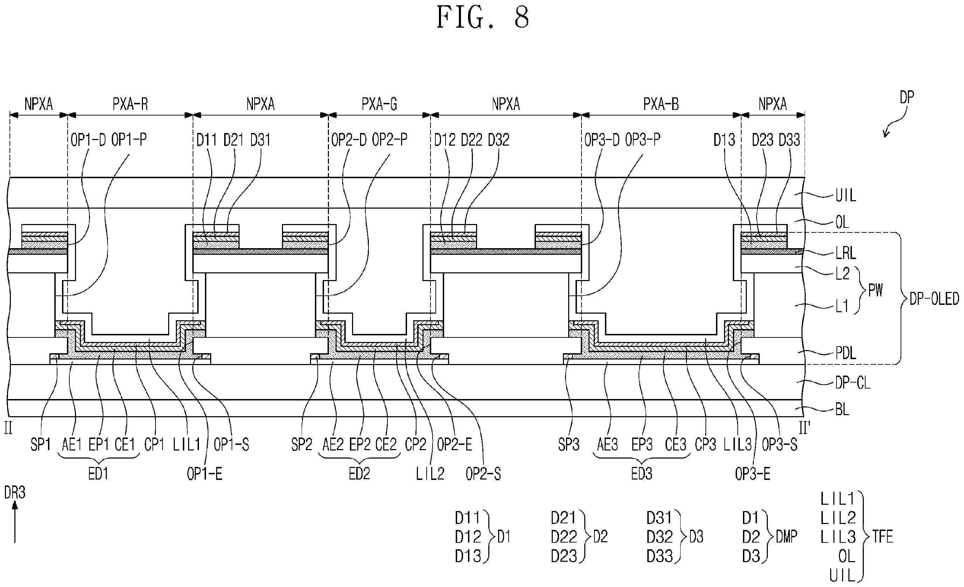

The light-blocking pattern BM may prevent reflection of external light by the conductive layers included in the input sensor INS. The light-blocking pattern BM may be disposed to overlap a pixel defining film PDL (refer to FIG. 8).

The color filter CF may include a first color filter CF1, a second color filter CF2, and a third color filter CF3. The first to third color filters CF1, CF2, and CF3 may overlap first to third light-emitting areas PXA-R, PXA-G, and PXA-B (refer to FIG. 8), respectively. In an embodiment, the first color filter CF1 may overlap a first light-emitting element ED1 (refer to FIG. 8), the second color filter CF2 may overlap a second light-emitting element ED2 (refer to FIG. 8), and the third color filter CF3 may overlap a third light-emitting element ED3 (refer to FIG. 8), for example. The first to third color filters CF1, CF2, and CF3 may correspond to the first to third light-emitting elements ED1, ED2, and ED3 (refer to FIG. 8) and transmit light generated by the first to third light-emitting elements ED1, ED2, and ED3, and block a partial wavelength band of external light.

The first color filter CF1 may transmit light of a first color, the second color filter CF2 may transmit light of a second color, and the third color filter CF3 may transmit light of a third color. The second color may be different from the first color, and the third color may be different from the first color and the second color. In an embodiment, the first color may be red, the second color may be green, and the third color may be blue, for example. The first to third color filters CF1, CF2, and CF3 may reduce reflection of external light by first to third anodes AE1, AE2, and AE3 (refer to FIG. 8) or cathodes CE1, CE2, and CE3 (refer to FIG. 8). Portions of the first to third color filters CF1, CF2, and CF3 may be disposed on the light-blocking pattern BM.

The overcoat layer OC may cover the light-blocking pattern BM, the first color filter CF1, the second color filter CF2, and the third color filter CF3. The overcoat layer OC may include or consist of an organic material and may provide a flat top surface.

FIG. 2B is a cross-sectional view of an embodiment of a display device according to the disclosure. In describing FIG. 2B, the description will be made with reference to FIG. 2A and descriptions of the same reference numerals will be omitted.

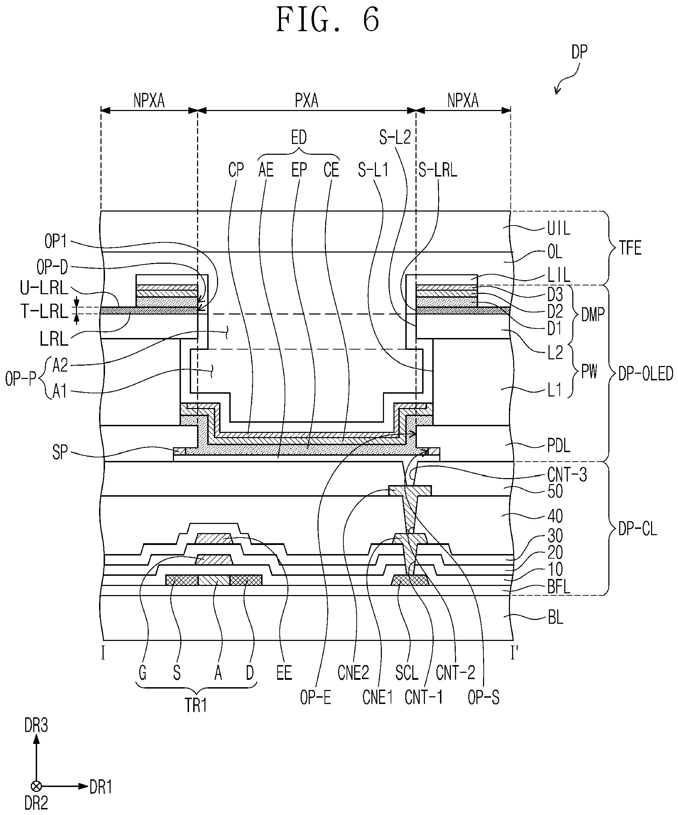

Referring to FIG. 2B, an anti-reflection layer ARL-1 may include the light-blocking pattern BM and a light control layer AR. The anti-reflection layer ARL-1 disposed on the display module DM may be a layer in which dyes and/or pigments are dispersed in a base resin without including a polarization layer. An entirety of the light control layer AR may overlap a display element layer DP-OLED (refer to FIG. 6). In an embodiment, the entirety of the light control layer AR may overlap the first to third light-emitting elements ED1, ED2, and ED3 (refer to FIG. 8), for example. The light control layer AR may be provided as one continuous layer. The light control layer AR may protect the display panel DP by covering a front surface of the display panel DP. The light control layer AR may improve a color reproducibility by absorbing a portion of light emitted from the display panel DP and transmitting a portion of the light. In an embodiment, the light control layer AR may improve the color reproducibility by selectively absorbing light in a predetermined wavelength area, for example.

The dyes and the pigments contained in the light control layer AR may be materials that transmit only light in a predetermined wavelength area of light emitted from the light-emitting elements ED1, ED2, and ED3 (refer to FIG. 8). In an embodiment, the dyes and the pigments may be a layer that absorbs light in a wavelength range equal to or higher than about 490 nanometers (nm) and equal to or lower than about 505 nm and light in a wavelength range equal to or higher than about 585 nm and equal to or lower than about 600 nm, and transmits the remaining portion of light. As the dyes and the pigments contained in the light control layer AR absorb light of the predetermined wavelength and transmit light in the remaining wavelength range, reflection by external light may be prevented and a color of light emitted from the display panel DP may be adjusted.

However, the anti-reflection layer ARL or ARL-1 in FIGS. 2A and 2B is shown as one embodiment. The disclosure is not limited thereto as long as the anti-reflection layer disposed on the display module DM does not include the polarization layer.

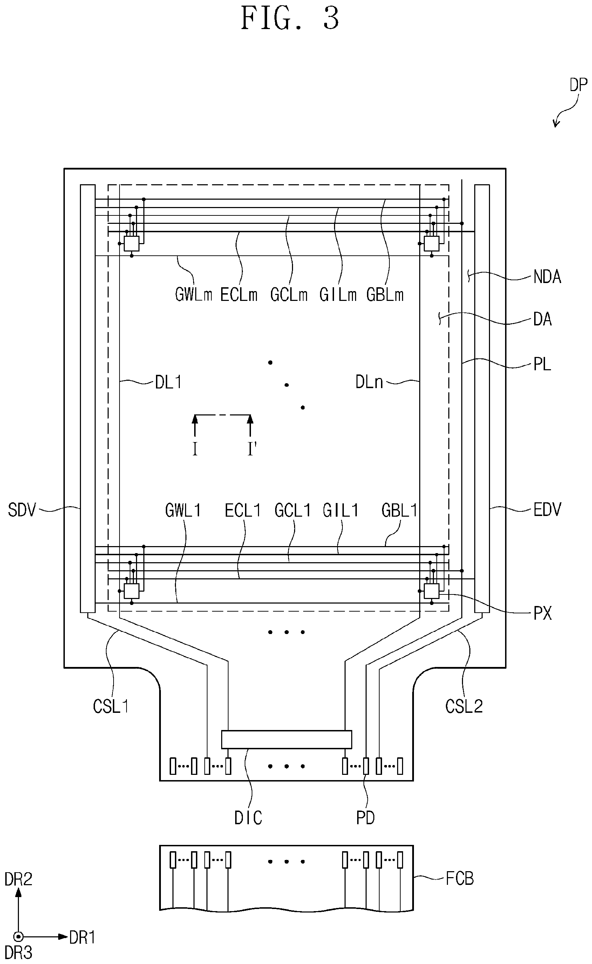

FIG. 3 is a plan view of an embodiment of a display panel according to the disclosure.

Referring to FIG. 3, the display area DA and the non-display area NDA around the display area DA may be defined in the display panel DP. The display area DA and the non-display area NDA may be distinguished from each other based on whether pixels PX are arranged. The pixels PX may be arranged in the display area DA, and the pixels PX may not be arranged in the non-display area NDA.

The display panel DP may include the pixels PX, initialization scan lines GIL1 to GILm, compensation scan lines GCL1 to GCLm, write scan lines GWL1 to GWLm, black scan lines GBL1 to GBLm, light emission control lines ECL1 to ECLm, data lines DL1 to DLn, first and second control lines CSL1 and CSL2, a driving voltage line PL, a scan driver SDV, a data driver, a light-emitting driver EDV, a driving chip DIC, and pads PD. Here, 'm' and 'n' are natural numbers equal to or greater than 2. The data driver may be a partial circuit constructed in the driving chip DIC.

The pixels PX may be connected to the initialization scan lines GIL1 to GILm, the compensation scan lines GCL1 to GCLm, the write scan lines GWL1 to GWLm, the black scan lines GBL1 to GBLm, the light emission control lines ECL1 to ECLm, and the data lines DL1 to DLn.

The initialization scan lines GIL1 to GILm, the compensation scan lines GCL1 to GCLm, the write scan lines GWL1 to GWLm, and the black scan lines GBL 1 to GBLm may be extended in the first direction DR1 and electrically connected to the scan driver SDV. The data lines DL1 to DLn may be extended in the second direction DR2 and electrically connected to the driving chip DIC. The light emission control lines ECL1 to ECLm may extend in the first direction DR1 and may be electrically connected to the light-emitting driver EDV.

The driving voltage line PL may include a portion extended in the first direction DR1 and a portion extended in the second direction DR2. The portion extended in the first direction DR1 and the portion extended in the second direction DR2 may be disposed in different layers. The driving voltage line PL may provide a driving voltage to the pixels PX.

The first control line CSL1 may be connected to the scan driver SDV. The second control line CSL2 may be connected to the light-emitting driver EDV.

The driving chip DIC, the driving voltage line PL, the first control line CSL1, and the second control line CSL2 may be electrically connected to the pads PD. A flexible circuit film FCB may be electrically connected to the pads PD via an anisotropic conductive adhesive layer. The pads PD may be pads for connecting the flexible circuit film FCB to the display panel DP. The pads PD may be connected to the corresponding pixels PX via the driving voltage line PL, the first control line CSL1, and the second control line CSL2.

In addition, the pads PD may further include input pads. The input pads may be pads for connecting the flexible circuit film FCB to the input sensor INS (refer to FIG. 2A). However, the disclosure may not be limited thereto, and the input pads may be disposed on the input sensor INS and connected to a separate circuit board. In an alternative embodiment, the input sensor INS may be omitted, and the display panel DP may not further include the input pads.

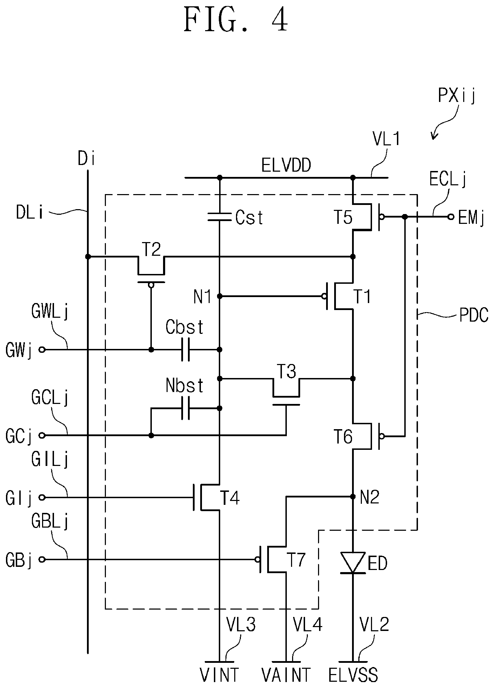

FIG. 4 is an equivalent circuit diagram of an embodiment of a pixel according to the disclosure.

In FIG. 4, an equivalent circuit diagram of one pixel PXij among the plurality of pixels PX (refer to FIG. 3) is shown as one embodiment. Because the plurality of pixels PX has the same circuit structure, a description of a circuit structure of the pixel PXij replaces a detailed description of the remaining pixels PX.

Referring to FIGS. 3 and 4, the pixel PXij is connected to the i-th data line DLi among the data lines DL1 to DLn, the j-th initialization scan line GILj among the initialization scan lines GIL1 to GILm, the j-th compensation scan line GCLj among the compensation scan lines GCL1 to GCLm, the j-th write scan line GWLj among the write scan lines GWL1 to GWLm, the j-th black scan line GBLj among the black scan lines GBL1 to GBLm, the j-th light emission control line ECLj among the light emission control lines ECL1 to ECLm, first and second driving voltage lines VL1 and VL2, and first and second initialization voltage lines VL3 and VL4. Here, 'i' is an integer equal to or greater than 1 and equal to or smaller than 'n', and 'j' is an integer equal to or greater than 1 and equal to or smaller than 'm'.

The pixel PXij includes a light-emitting element ED and a pixel circuit PDC. The light-emitting element ED may be a light-emitting diode. In an embodiment of the disclosure, the light-emitting element ED may be an organic light-emitting diode including an organic light-emitting layer, but may not be particularly limited thereto. The pixel circuit PDC may control an amount of current flowing through the light-emitting element ED in response to a data signal Di. The light-emitting element ED may emit light with a predetermined luminance corresponding to the amount of current provided from the pixel circuit PDC.

The pixel circuit PDC may include first to seventh transistors T1, T2, T3, T4, T5, T6, and T7, and first to third capacitors Cst, Cbst, and Nbst. According to the disclosure, a configuration of the pixel circuit PDC is not limited to the embodiment shown in FIG. 4. The pixel circuit PDC illustrated in FIG. 4 is only one the of embodiments, and the configuration of the pixel circuit PDC may be modified.

At least one of the first to seventh transistors T1, T2, T3, T4, T5, T6, and T7 may be a transistor having a low-temperature polycrystalline silicon ("LTPS") semiconductor layer. At least one of the first to seventh transistors T1, T2, T3, T4, T5, T6, and T7 may be a transistor having an oxide semiconductor layer. In an embodiment, the third and fourth transistors T3 and T4 may be oxide semiconductor transistors, and the first, second, fifth, sixth, and seventh transistors T1, T2, T5, T6, and T7 may be LTPS transistors, for example.

Specifically, the first transistor T1 that directly affects brightness of the light-emitting element ED may include a polycrystalline silicon semiconductor layer with relatively high reliability. With the first transistor T1, a high-resolution display device may be implemented. Because an oxide semiconductor has relatively high carrier mobility and relatively low leakage current, a voltage drop is not great even when a driving time is long. That is, because a color change of the image resulted from the voltage drop is not great even during low-frequency driving, low-frequency driving is possible. As such, because the oxide semiconductor has an advantage of relatively low leakage current, at least one of the third transistor T3 and the fourth transistor T4 connected to a gate electrode of the first transistor T1 may be used as the oxide semiconductor to prevent the leakage current that may flow to the gate electrode and at the same time reduce power consumption.

Some of the first to seventh transistors T1, T2, T3, T4, T5, T6, and T7 may be P-type transistors, and others may be N-type transistors. In an embodiment, the first, second, fifth, sixth, and seventh transistors T1, T2, T5, T6, and T7 may be the P-type transistors, and the third and fourth transistors T3 and T4 may be the N-type transistors, for example.

The configuration of the pixel circuit PDC according to the disclosure is not limited to the embodiment shown in FIG. 4. The pixel circuit PDC shown in FIG. 4 is only one of the embodiments, and the configuration of the pixel circuit PDC is able to be modified. In an embodiment, all of the first to seventh transistors T1, T2, T3, T4, T5, T6, and T7 may be the P-type transistors or the N-type transistors, for example. In an alternative embodiment, the first, second, fifth, and sixth transistors T1, T2, T5, and T6 may be the P-type transistors and the third, fourth, and seventh transistors T3, T4, and T7 may be the N-type transistors.

The j-th initialization scan line GILj, the j-th compensation scan line GCLj, the j-th write scan line GWLj, the j-th black scan line GBLj, and the j-th light emission control line ECLj may transfer respectively a j-th initialization scan signal GIj, a j-th compensation scan signal GCj, a j-th write scan signal GWj, a j-th black scan signal GBj, and a j-th light emission control signal EMj to the pixel PXij, respectively. The i-th data line DLi transfers the i-th data signal Di to the pixel PXij. The i-th data signal Di may have a voltage level corresponding to an image signal input to the display device DD (refer to FIG. 1).

The first and second driving voltage lines VL1 and VL2 may transfer a first driving voltage ELVDD and a second driving voltage ELVSS to the pixel PXij, respectively. In addition, the first and second initialization voltage lines VL3 and VL4 may transfer a first initialization voltage VINT and a second initialization voltage VAINT to the pixel PXij, respectively.

The first transistor T1 is disposed between and connected to the light-emitting element ED and the first driving voltage line VL1 that receives the first driving voltage ELVDD. The first transistor T1 includes a first electrode connected to the first driving voltage line VL1 via the fifth transistor T5, a second electrode connected to a pixel electrode (or referred to as an anode) of the light-emitting element ED via the sixth transistor T6, and a third electrode (e.g., the gate electrode) connected to one end (e.g., a first node N1) of the first capacitor Cst. The first transistor T1 may receive the i-th data signal Di transferred by the i-th data line DLi based on a switching operation of the second transistor T2 and supply a driving current to the light-emitting element ED.

The second transistor T2 is disposed between and connected to the data line DLi and the first electrode of the first transistor T1. The second transistor T2 includes a first electrode connected to the data line DLi, a second electrode connected to the first electrode of the first transistor T1, and a third electrode (e.g., a gate electrode) connected to the j-th write scan line GWLj. The second transistor T2 may be turned on in response to the write scan signal GWj transferred via the j-th write scan line GWLj and transfer the i-th data signal Di transferred from the i-th data line DLi to the first electrode of the first transistor T1. One end of the second capacitor Cbst may be connected to the third electrode of the second transistor T2, and the other end of the second capacitor Cbst may be connected to the first node N1.

The third transistor T3 is disposed between and connected to the second electrode of the first transistor T1 and the first node N1. The third transistor T3 includes a first electrode connected to the third electrode of the first transistor T1, a second electrode connected to the second electrode of the first transistor T1, and a third electrode (e.g., a gate electrode) connected to the j-th compensation scan line GCLj. The third transistor T3 may be turned on in response to the j-th compensation scan signal GCj transferred via the j-th compensation scan line GCLj, and connect the third electrode of the first transistor T1 and the second electrode of the first transistor T1 to each other to diode-connect the first transistor T1. One end of the third capacitor Nbst may be connected to the third electrode of the third transistor T3, and the other end of the third capacitor Nbst may be connected to the first node N1.

The fourth transistor T4 is disposed between and connected to the first node N1 and the first initialization voltage line VL3 to which the first initialization voltage VINT is applied. The fourth transistor T4 includes a first electrode connected to the first initialization voltage line VL3 to which the first initialization voltage VINT is transferred, a second electrode connected to the first node N1, and a third electrode (e.g., a gate electrode) connected to the j-th initialization scan line GILj. The fourth transistor T4 is turned on in response to the j-th initialization scan signal GIj transferred via the j-th initialization scan line GILj. The turned-on fourth transistor T4 transfers the first initialization voltage VINT to the first node N1 to initialize a potential of the third electrode (i.e., a potential of the first node N1) of the first transistor T1.

The fifth transistor T5 includes a first electrode connected to the first driving voltage line VL1, a second electrode connected to the first electrode of the first transistor T1, and a third electrode (e.g., a gate electrode) connected to the j-th light emission control line ECLj. The sixth transistor T6 includes a first electrode connected to the second electrode of the first transistor T1, a second electrode connected to the pixel electrode of the light-emitting element ED, and a third electrode (e.g., a gate electrode) connected to the j-th light emission control line ECLj.

The fifth and sixth transistors T5 and T6 are simultaneously turned on in response to the j-th light emission control signal EMj transferred via the j-th light emission control line ECLj. The first driving voltage ELVDD applied via the turned-on fifth transistor T5 may be compensated for via the diode-connected first transistor T1 and then transferred to the light-emitting element ED via the sixth transistor T6.

The seventh transistor T7 includes a first electrode connected to the second initialization voltage line VL4 to which the second initialization voltage VAINT is transferred, a second electrode connected to the second electrode of the sixth transistor T6, i.e., a second node N2, and a third electrode (e.g., a gate electrode) connected to the j-th black scan line GBLj. The second initialization voltage VAINT may have a voltage level lower than or equal to that of the first initialization voltage VINT.

One end of the first capacitor Cst may be connected to the third electrode of the first transistor T1, and the other end of the first capacitor Cst may be connected to the first driving voltage line VL1. A cathode of the light-emitting element ED may be connected to the second driving voltage line VL2 that transfers the second driving voltage ELVSS. The second driving voltage ELVSS may have a voltage level lower than that of the first driving voltage ELVDD.

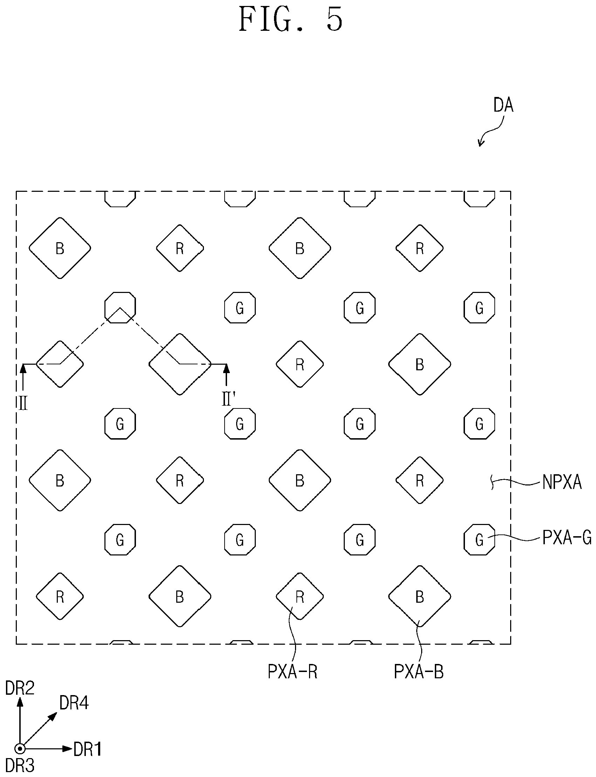

FIG. 5 is an enlarged plan view of an embodiment of a portion of a display area of a display panel according to the disclosure. FIG. 5 is a plan view of the display module DM viewed from the display surface IS (refer to FIG. 1B) of the display module DM (refer to FIG. 1B), and shows arrangement of the light-emitting areas PXA-R, PXA-G, and PXA-B.

Referring to FIG. 5, the display area DA may include the first to third light-emitting areas PXA-R, PXA-G, and PXA-B and a peripheral area NPXA surrounding the first to third light-emitting areas PXA-R, PXA-G, and PXA-B. The first to third light-emitting areas PXA-R, PXA-G, and PXA-B may respectively correspond to areas from which light provided from the light-emitting elements is emitted. The first to third light-emitting areas PXA-R, PXA-G, and PXA-B may be distinguished from each other based on a color of light emitted to the outside of the display module DM (refer to FIG. 1B).

The first to third light-emitting areas PXA-R, PXA-G, and PXA-B may provide first to third color light having different colors, respectively. In an embodiment, the first color light may be red light, the second color light may be green light, and the third color light may be blue light, for example. However, embodiments of the first to third color light are not necessarily limited to the above example.

Each of the first to third light-emitting areas PXA-R, PXA-G, and PXA-B may be defined as an area where a top surface of the anode is exposed by a light-emitting opening to be described later. The peripheral area NPXA may set boundaries of the first to third light-emitting areas PXA-R, PXA-G, and PXA-B, and prevent a color mixture between the first to third light-emitting areas PXA-R, PXA-G, and PXA-B.

The first to third light-emitting areas PXA-R, PXA-G, and PXA-B may include a plurality of first light-emitting areas, a plurality of second light-emitting areas, and a plurality of third light-emitting areas, respectively, may be repeatedly arranged in a predetermined arrangement within the display area DA. In an embodiment, the first and third light-emitting areas PXA-R and PXA-B may be alternately arranged along the first direction DR1 to constitute a 'first group', for example. The second light-emitting areas PXA-G may be arranged along the first direction DR1 to constitute a 'second group'. The 'first group' and the 'second group' may include a plurality of first groups and a plurality of second groups, respectively, and the 'first groups' and the 'second groups' may be alternately arranged along the second direction DR2.

The one second light-emitting area PXA-G may be disposed so as to be spaced apart from the one first light-emitting area PXA-R or the one third light-emitting area PXA-B in a fourth direction DR4. The fourth direction DR4 may be defined as a direction between the first direction and the second direction DR1 and DR2.

FIG. 5 shows the arrangement of the first to third light-emitting areas PXA-R, PXA-G, and PXA-B as one embodiment. The disclosure may not be limited thereto, and the first to third light-emitting areas PXA-R, PXA-G, and PXA-B may be arranged in various forms. In an embodiment, the first to third light-emitting areas PXA-R, PXA-G, and PXA-B may have a PENTILE^{™} arrangement as shown in FIG. 5. In an alternative embodiment, the first to third light-emitting areas PXA-R, PXA-G, and PXA-B may have a stripe arrangement or a diamond Pixel^{™} arrangement.

The first to third light-emitting areas PXA-R, PXA-G, and PXA-B may have various shapes in a plan view. In an embodiment, the first to third light-emitting areas PXA-R, PXA-G, and PXA-B may have a polygonal, circular, or elliptical shape, for example. FIG. 5 shows the first and third light-emitting areas PXA-R and PXA-B having a quadrangular shape (or a rhombus shape) and the second light-emitting area PXA-G having an octagonal shape in a plan view as one embodiment.

The first to third light-emitting areas PXA-R, PXA-G, and PXA-B may have the same shape in the plan view, or at least some of them may have different shapes. FIG. 5 shows the first and third light-emitting areas PXA-R and PXA-B having the same shape and the second light-emitting area PXA-G having a shape different from that of the first and third light-emitting areas PXA-R and PXA-B in the plan view as one embodiment.

At least some of the first to third light-emitting areas PXA-R, PXA-G, and PXA-B may have different area sizes from each other in the plan view. In an embodiment, an area size of the first light-emitting area PXA-R emitting the red light is greater than an area size of the second light-emitting area PXA-G emitting the green light and smaller than an area size of the third light-emitting area PXA-B emitting the blue light. However, an area size relationship between the first to third light-emitting areas PXA-R, PXA-G, and PXA-B based on the color of emitted light is not limited thereto and varies depending on a design of the display module DM (refer to FIG. 1B). In addition, without being limited thereto, the first to third light-emitting areas PXA-R, PXA-G, and PXA-B may have the same area size as each other in the plan view.

The shapes, the area sizes, the arrangement, or the like of the first to third light-emitting areas PXA-R, PXA-G, and PXA-B of the display module DM according to the disclosure may be variously designed based on the color of emitted light and a size and a configuration of the display module DM, and may not be limited to the embodiment shown in FIG. 5.

FIG. 6 is a cross-sectional view of an embodiment of a display panel according to the disclosure taken along line I-I' in FIG. 3.

FIG. 6 is an enlarged view of one light-emitting area PXA in the display area DA (refer to FIG. 5). The light-emitting area PXA in FIG. 6 may correspond to one of the first to third light-emitting areas PXA-R, PXA-G, and PXA-B.

Referring to FIG. 6, the display panel DP may include a base layer BL, a circuit element layer DP-CL, the display element layer DP-OLED, and a thin film encapsulation layer TFE. The display panel DP may include a plurality of insulating layers, a semiconductor pattern, a conductive pattern, a signal line, or the like. The insulating layer, a semiconductor layer, and a conductive layer are formed by schemes such as coating and deposition. Thereafter, the insulating layer, the semiconductor layer, and the conductive layer may be selectively patterned via photolithography and etching. In such scheme, the semiconductor pattern, the conductive pattern, the signal lines, or the like included in the circuit element layer DP-CL and the display element layer DP-OLED may be formed.

The base layer BL may include at least one plastic film. The base layer BL, as a flexible substrate, may include a plastic substrate, a glass substrate, a metal substrate, or an organic/inorganic composite material substrate.

The circuit element layer DP-CL may be disposed on the base layer BL. The circuit element layer DP-CL may include a buffer layer BFL, a transistor TR1, a signal transfer area SCL, first to fifth insulating layers 10, 20, 30, 40, and 50, an electrode EE, and a plurality of connection electrodes CNE1 and CNE2.

The buffer layer BFL may be disposed on the base layer BL. The buffer layer BFL may improve a coupling force between the base layer BL and the semiconductor pattern. The buffer layer BFL may include a silicon oxide layer and a silicon nitride layer. The silicon oxide layer and the silicon nitride layer may be alternately stacked.

The semiconductor pattern may be disposed on the buffer layer BFL. The semiconductor pattern may include or consist of polysilicon. However, without being limited thereto, the semiconductor pattern may include or consist of amorphous silicon or metal oxide. FIG. 6 only shows a portion of the semiconductor pattern in an embodiment, and the semiconductor pattern may be further disposed in the plurality of light-emitting areas PXA-R, PXA-G, and PXA-B (refer to FIG. 5). The semiconductor pattern may be arranged in a predetermined rule over the plurality of light-emitting areas PXA-R, PXA-G, and PXA-B. The semiconductor pattern may have different electrical properties depending on whether it is doped. The semiconductor pattern may include a first area having a relatively high doping concentration and a second area having a relatively low doping concentration. The first area may be doped with an N-type dopant or a P-type dopant. The P-type transistor may include a first area doped with the P-type dopant.

The first area has greater conductivity than the second area and substantially serves as the electrode or the signal line. The second area may substantially correspond to an active (or a channel) of the transistor. In other words, a portion of the semiconductor pattern may be the active of the transistor, another portion may be a source or a drain of the transistor, and another portion may be a conductive area.

A source S, an active A, and a drain D of the transistor TR1 may be formed from the semiconductor pattern. FIG. 6 shows a portion of the signal transfer area SCL formed from the semiconductor pattern. Although not separately shown, the signal transfer area SCL may be connected to the drain D of transistor TR1 in a plan view.

The first to fifth insulating layers 10, 20, 30, 40, and 50 may be disposed on the buffer layer BFL. The first to fifth insulating layers 10, 20, 30, 40, and 50 may be inorganic layers or organic layers.

The first insulating layer 10 may be disposed on the buffer layer BFL. The first insulating layer 10 may cover the source S, the active A, and the drain D of the transistor TR1 and the signal transfer area SCL disposed on the buffer layer BFL. The gate G of the transistor TR1 may be disposed on the first insulating layer 10. The second insulating layer 20 may be disposed on the first insulating layer 10 to cover the gate G. The electrode EE may be disposed on the second insulating layer 20. The third insulating layer 30 may be disposed on the second insulating layer 20 to cover the electrode EE.

The first connection electrode CNE1 may be disposed on the third insulating layer 30. The first connection electrode CNE1 may be connected to the signal transfer area SCL via a contact hole CNT-1 extending through the first to third insulating layers 10, 20, and 30. The fourth insulating layer 40 may be disposed on the third insulating layer 30 to cover the first connection electrode CNE1. The fourth insulating layer 40 may be the organic layer.

The second connection electrode CNE2 may be disposed on the fourth insulating layer 40. The second connection electrode CNE2 may be connected to the first connection electrode CNE1 via a contact hole CNT-2 extending through the fourth insulating layer 40. The fifth insulating layer 50 may be disposed on the fourth insulating layer 40 to cover the second connection electrode CNE2. The fifth insulating layer 50 may be the organic layer.

The display element layer DP-OLED may be disposed on the circuit element layer DP-CL. The display element layer DP-OLED may include the light-emitting element ED, a sacrificial pattern SP, the pixel defining film PDL, a partition wall PW, a low reflection layer LRL, and dummy patterns DMP. The light-emitting element ED may include an anode (or a first electrode) AE, a light-emitting pattern EP, and a cathode (or a second electrode) CE.

The anode AE may be disposed on the fifth insulating layer 50 of the circuit element layer DP-CL. The anode AE may be a transmissive electrode, a transflective electrode, or a reflective electrode. The anode AE may be connected to the second connection electrode CNE2 via a connection contact hole CNT-3 defined through the fifth insulating layer 50. Accordingly, the anode AE may be electrically connected to the signal transfer area SCL via the first and second connection electrodes CNE1 and CNE2 and electrically connected to a corresponding circuit element. The anode AE may include a single-layer or multi-layer structure. The anode AE may include a plurality of layers including or consisting of indium tin oxide ("ITO") and Ag. In an embodiment, the anode AE may include a layer including or consisting of ITO (hereinafter, also referred to as a lower ITO layer), a layer including or consisting of Ag (hereinafter, also referred to as an Ag layer) disposed on the lower ITO layer, and a layer including or consisting of ITO (hereinafter, an upper ITO layer) disposed on the Ag layer, for example.

The sacrificial pattern SP may be disposed between the anode AE and the pixel defining film PDL. A sacrificial opening OP-S that exposes a portion of the top surface of the anode AE may be defined in the sacrificial pattern SP. The sacrificial opening OP-S may overlap a light-emitting opening OP-E to be described later.

The pixel defining film PDL may be disposed on the fifth insulating layer 50 of the circuit element layer DP-CL. The light-emitting opening OP-E may be defined in the pixel defining film PDL. The light-emitting opening OP-E may correspond to the anode AE, and the pixel defining film PDL may expose at least a portion of the anode AE via the light-emitting opening OP-E.

In addition, the light-emitting opening OP-E may correspond to the sacrificial opening OP-S of the sacrificial pattern SP. In the illustrated embodiment, the top surface of the anode AE may be spaced apart from the pixel defining film PDL in a cross-section with the sacrificial pattern SP interposed therebetween, and accordingly, protect the anode AE from damage in a process of defining the light-emitting opening OP-E.

On a plane, an area size of the light-emitting opening OP-E may be smaller than an area size of the sacrificial opening OP-S. That is, an inner surface of the pixel defining film PDL that defines the light-emitting opening OP-E may be closer to a center of the anode AE than an inner surface of the sacrificial pattern SP that defines the sacrificial opening OP-S is to the center of the anode AE. However, the disclosure may not be limited thereto, and the inner surface of the sacrificial pattern SP that defines the sacrificial opening OP-S may be substantially aligned with the inner surface of the pixel defining film PDL that defines the light-emitting opening OP-E. In this regard, the light-emitting area PXA may be regarded as an area of the anode AE exposed via the corresponding sacrificial opening OP-S.

The pixel defining film PDL may include or consist of an inorganic insulating material. In an embodiment, silicon nitride (SiNₓ) may be contained, for example. The pixel defining film PDL may be disposed between the anode AE and the partition wall PW to block electrical connection between the anode AE and the partition wall PW.

The light-emitting pattern EP may be disposed on the anode AE. The light-emitting pattern EP may include a light-emitting layer including or consisting of a light-emitting material. The light-emitting pattern EP may further include a hole injection layer ("HIL") and a hole transport layer ("HTL") disposed between the anode AE and the light-emitting layer, and may further include an electron transport layer ("ETL") and an electron injection layer ("EIL") disposed on the light-emitting layer. The light-emitting pattern EP may also be referred to as an 'organic layer' or an 'intermediate layer'.

The light-emitting pattern EP may be patterned by a tip defined on the partition wall PW. The light-emitting pattern EP may be disposed inside the sacrificial opening OP-S, the light-emitting opening OP-E, and a partition wall opening OP-P. The light-emitting pattern EP may cover a portion of a top surface of the pixel defining film PDL exposed via the partition wall opening OP-P.

In an embodiment, although FIG. 6 shows an embodiment that the light-emitting pattern EP contacts a first inner surface S-L1 of a first partition wall layer L1, the disclosure is not limited thereto. In an embodiment, the light-emitting pattern EP may not contact the first inner surface S-L1 of the first partition wall layer L1, for example.

The cathode CE may be disposed on the light-emitting pattern EP. The cathode CE may be patterned by the tip defined on the partition wall PW. At least a portion of the cathode CE may be disposed in the partition wall opening OP-P. The cathode CE may contact the first inner surface S-L1 of the first partition wall layer L1. The cathode CE may have conductivity. The cathode CE may include or consist of various materials as long as the materials have the conductivity, such as metal, transparent conductive oxide ("TCO"), or a conductive polymer material. In an embodiment, the cathode CE may include or consist of silver (Ag), magnesium (Mg), lead (Pb), copper (Cu), or any combinations thereof, for example.

The partition wall PW may be disposed on the pixel defining film PDL. The partition wall opening OP-P may be defined in the partition wall PW. The partition wall opening OP-P may correspond to the light-emitting opening OP-E and may expose at least a portion of the anode AE.

The partition wall PW may have an undercut shape in a cross-section. The partition wall PW may include multiple layers sequentially stacked, and at least one of the multiple layers may be recessed compared to other layers. Accordingly, the partition wall PW may include the tip.

The partition wall PW may include the first partition wall layer L1 and a second partition wall layer L2. The first partition wall layer L1 may be disposed on the pixel defining film PDL, and the second partition wall layer L2 may be disposed on the first partition wall layer L1. As shown in FIG. 6, a thickness of the first partition wall layer L1 may be greater than a thickness of the second partition wall layer L2, but the disclosure may not be limited thereto.

The first partition wall layer L1 may be more recessed than the second partition wall layer L2 with respect to the light-emitting area PXA. The first partition wall layer L1 may be undercut with respect to the second partition wall layer L2. A portion of the second partition wall layer L2 protruding from the first partition wall layer L1 toward the light-emitting area PXA may be defined as the tip within the partition wall PW.

The partition wall opening OP-P defined in the partition wall PW may include a first area A1 and a second area A2. The first partition wall layer L1 may include the first inner surface S-L1 that defines the first area A1 of the partition wall opening OP-P, and the second partition wall layer L2 may include a second inner surface S-L2 that defines the second area A2. In a cross-section, the second inner surface S-L2 of the second partition wall layer L2 may be closer to the center of the anode AE than the first inner surface S-L1 of the first partition wall layer L1 is to the center of the anode AE. The first inner surface S-L1 may be more recessed in a direction farther from the center of the anode AE than the second inner surface S-L2. Accordingly, the second partition wall layer L2 protruding toward the light-emitting area PXA may include the tip.

A width of the first area A1 may be different from a width of the second area A2. The width of the first area A1 may be greater than the width of the second area A2. In this case, the second area A2 of the partition wall opening OP-P may be an area defining the tip.

Each of the first partition wall layer L1 and the second partition wall layer L2 may include or consist of a conductive material. In an embodiment, the conductive material may include a metal, a transparent conductive oxide ("TCO"), or any combinations thereof, for example. In an embodiment, the metal may include gold (Au), silver (Ag), aluminium (Al), magnesium (Mg), lithium (Li), molybdenum (Mo), titanium (Ti), copper (Cu), or an alloy, for example. The transparent conductive oxide may include ITO, indium zinc oxide ("IZO"), zinc oxide, indium oxide, indium gallium oxide, indium gallium zinc oxide ("IGZO"), or aluminium zinc oxide.

The partition wall PW may receive the second driving voltage ELVSS (refer to FIG. 4), and accordingly, the cathode CE may be electrically connected to the partition wall PW to receive the second driving voltage ELVSS (refer to FIG. 4).

FIG. 6 shows an embodiment that each of the first inner surface S-L1 and the second inner surface S-L2 is perpendicular to the top surface of the pixel defining film PDL, but the disclosure is not limited thereto. In an embodiment, the partition wall PW may have a tapered shape or a reverse tapered shape, for example.

The low reflection layer LRL may be disposed on the partition wall PW. The low reflection layer LRL may include or consist of a light absorbing material. As the display panel DP includes the low reflection layer LRL disposed on the partition wall PW, the reflectance of external light reflected from a top surface of the partition wall PW may be reduced. In addition, the low reflection layer LRL may not have a color resulted from an interference effect of external light.

In an embodiment, the low reflection layer LRL may include or consist of amorphous silicon (a-Si). In an embodiment, the low reflection layer LRL may include or consist of silicon carbide (SiC). When the low reflection layer LRL includes or consists of the amorphous silicon (a-Si) or the silicon carbide (SiC), a thickness T-LRL of the low reflection layer LRL may be equal to or greater than about 30 angstroms (Å) and equal to or smaller than about 150 angstroms (Å). In another embodiment, the low reflection layer LRL may include or consist of molybdenum oxide (MoOₓ). In this case, the thickness of the low reflection layer LRL may be equal to or greater than about 200 angstroms (Å) and equal to or smaller than about 500 angstroms (Å).

A first opening OP1 that overlaps the partition wall opening OP-P may be defined in the low reflection layer LRL. The first opening OP1 may overlap the partition wall opening OP-P. The low reflection layer LRL may include an inner surface S-LRL of the low reflection layer LRL that defines the first opening OP1. The inner surface S-LRL of the low reflection layer LRL may be aligned with the second inner surface S-L2 of the second partition wall layer L2 (or the inner surface of the second partition wall layer L2).

In an embodiment of the disclosure, the display panel DP may further include a capping pattern CP. The capping pattern CP may be disposed within the partition wall opening OP-P and may be disposed on the cathode CE. The capping pattern CP may be patterned by the tip formed on the partition wall PW.

FIG. 6 shows an embodiment that the capping pattern CP is not in contact with the first inner surface S-L1 of the first partition wall layer L1, but the disclosure is not limited thereto. In an embodiment, the capping pattern CP may be formed to contact the first inner surface S-L1 of the first partition wall layer L1, for example. In another embodiment of the disclosure, the capping pattern CP may be omitted.

The dummy patterns DMP may be disposed on the partition wall PW. The dummy patterns DMP may include a first dummy pattern D1, a second dummy pattern D2, and a third dummy pattern D3. The first to third dummy patterns D1, D2, and D3 may be sequentially stacked along the third direction DR3 on a top surface of the second partition wall layer L2 of the partition wall PW.

The first dummy pattern D1 may include or consist of an organic material. In an embodiment, the first dummy pattern D1 may include or consist of the same material as that of the light-emitting pattern EP. The first dummy pattern D1 may be simultaneously formed with the light-emitting pattern EP via one process, and formed separately from the light-emitting pattern EP by the undercut shape of the partition wall PW, for example.

The second dummy pattern D2 may include or consist of a conductive material. In an embodiment, the second dummy pattern D2 may include or consist of the same material as cathode CE, for example. The second dummy pattern D2 may be simultaneously formed with the cathode CE via one process, and formed separately from the cathode CE by the undercut shape of the partition wall PW.

The third dummy pattern D3 may include or consist of the same material as that of the capping pattern CP. The third dummy pattern D3 may be simultaneously formed with the capping pattern CP via one process, and formed separately from the capping pattern CP by the undercut shape of the partition wall PW.

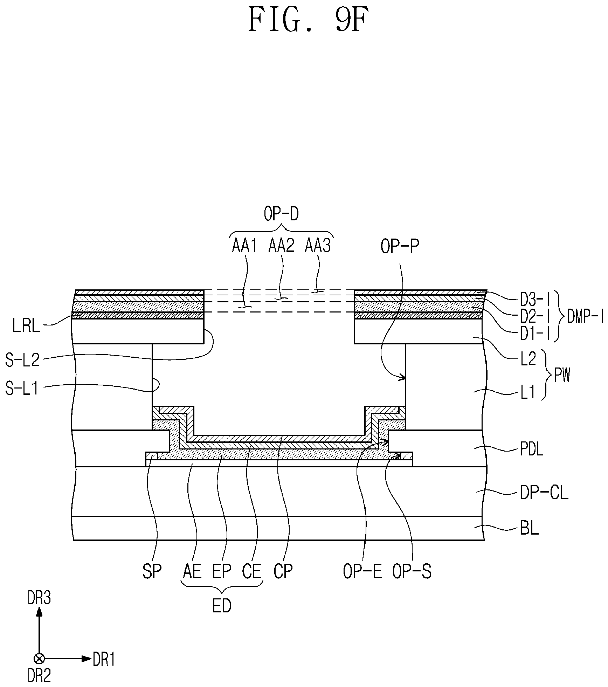

A dummy opening OP-D may be defined in the dummy patterns DMP. The dummy opening OP-D may correspond to the light-emitting opening OP-E. The dummy opening OP-D may include first to third areas AA1, AA2, and AA3 (refer to FIG. 9F) sequentially arranged in the third direction DR3. The first area AA1 of the dummy opening OP-D may be defined by an inner surface of the first dummy pattern D1, the second area AA2 may be defined by an inner surface of the second dummy pattern D2, and the third area AA3 may be defined by an inner surface of the third dummy pattern D3. On a plane, each of the first to third dummy patterns D1, D2, and D3 may have a closed-line shape surrounding the light-emitting area PXA.

FIG. 6 shows an embodiment that the inner surfaces of the first to third dummy patterns D1, D2, and D3 and the second inner surface S-L2 of the second partition wall layer L2 are aligned with each other, but the disclosure is not limited thereto. The first to third dummy patterns D1, D2, and D3 may cover the second inner surface S-L2 of the second partition wall layer L2.

The thin film encapsulation layer TFE may be disposed on the display element layer DP-OLED and may cover the display element layer DP-OLED. In an embodiment, the thin film encapsulation layer TFE may cover the partition wall PW and the light-emitting element ED, for example. The thin film encapsulation layer TFE may include a lower encapsulation inorganic pattern LIL, an encapsulation organic film OL, and an upper encapsulation inorganic film UIL.

The lower encapsulation inorganic pattern LIL may correspond to the light-emitting opening OP-E. The lower encapsulation inorganic pattern LIL may cover the light-emitting element ED and the dummy patterns DMP, and a portion thereof may be disposed within the partition wall opening OP-P. In an embodiment, the lower encapsulation inorganic pattern LIL may contact the first inner surface S-L1 of the first partition wall layer L1.

The encapsulation organic film OL may cover the lower encapsulation inorganic pattern LIL and provide a flat top surface. The upper encapsulation inorganic film UIL may be disposed on the encapsulation organic film OL.

The lower encapsulation inorganic pattern LIL and the upper encapsulation inorganic film UIL may protect the display element layer DP-OLED from moisture/oxygen, and the encapsulation organic film OL may protect the display element layer DP-OLED from foreign substances such as dust particles.

In an embodiment, the low reflection layer LRL may contact a portion of the thin film encapsulation layer TFE. In an embodiment, the inner surface S-LRL of the low reflection layer LRL may contact the lower encapsulation inorganic pattern LIL of the thin film encapsulation layer TFE, and a top surface U-LRL of the low reflection layer LRL may contact the encapsulation organic film OL of the thin film encapsulation layer TFE, for example.

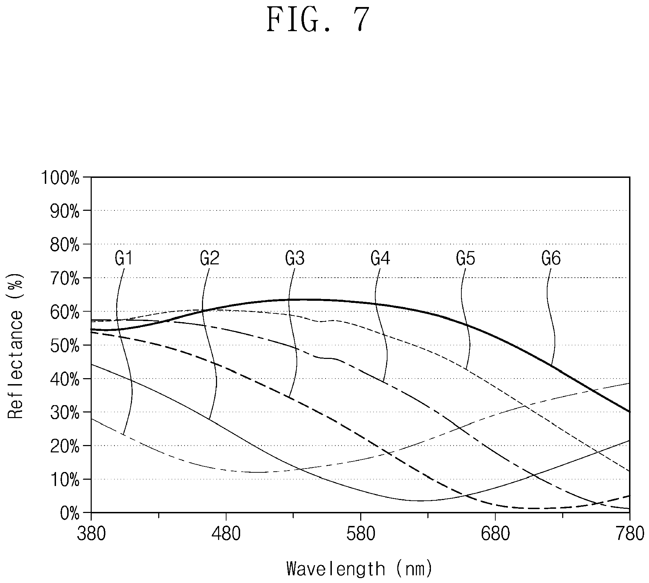

FIG. 7 shows reflectance graphs of an embodiment of a low reflection layer according to the disclosure.

FIG. 7 shows first to sixth graphs G1, G2, G3, G4, G5, and G6, and each of the first to sixth graphs G1, G2, G3, G4, G5, and G6 is a graph showing a reflectance for each wavelength of the low reflection layer LRL including or consisting of the amorphous silicon (a-Si). The first to sixth graphs G1, G2, G3, G4, G5, and G6 may be a graph showing the reflectance of the low reflection layer LRL having different thicknesses. In an embodiment, the first graph G1 may represent a reflectance of the low reflection layer LRL having a thickness of about 50 angstroms (Å), the second graph G2 may represent a reflectance of the low reflection layer LRL having a thickness of about 100 angstroms (Å), and the third graph G3 may represent a reflectance of the low reflection layer LRL having a thickness of about 150 angstroms (Å). The fourth graph G4 may represent a reflectance of the low reflection layer LRL having a thickness of about 200 angstroms (Å), the fifth graph G5 may represent a reflectance of the low reflection layer LRL having a thickness of about 250 angstroms (Å), and the sixth graph G6 may represent a reflectance of the low reflection layer LRL having a thickness of about 300 angstroms (Å).

Referring to FIGS. 6 and 7, the partition wall PW may include or consist of titanium (Ti) or aluminium (Al). A reflectance of aluminium (Al) may be about 100%, and a reflectance of titanium (Ti) may be about 55%.

In the first to third graphs G1, G2, and G3, the reflectance of the low reflection layer LRL having a thickness equal to or greater than about 50 angstroms (Å) and equal to or smaller than about 150 angstroms (Å) may be smaller than that of titanium (Ti) in all wavelength bands. In the fourth to sixth graphs G4, G5, and G6, the reflectance of the low reflection layer LRL having a thickness equal to or greater than about 200 angstroms (Å) and equal to or smaller than about 300 angstroms (Å) may be smaller than that of titanium (Ti) in some wavelength bands. It may be preferable that the thickness of the low reflection layer LRL is equal to or greater than about 50 angstroms (Å) and equal to or smaller than about 150 angstroms (Å). However, the thickness of the low reflection layer LRL may not be limited thereto, and the preferred thickness range may vary depending on the material contained in the low reflection layer LRL. In an embodiment, when the low reflection layer LRL includes or consists of the molybdenum oxide (MoOₓ), the thickness of the low reflection layer LRL may preferably be equal to or greater than about 200 angstroms (Å) and equal to or smaller than about 500 angstroms (Å), for example.

According to the disclosure, as the display panel DP includes the low reflection layer LRL disposed on the partition wall PW, external light may be reflected from the top surface U-LRL of the low reflection layer LRL, not from the top surface of the partition wall PW. As external light is reflected from the top surface U-LRL of the low reflection layer LRL including or consisting of the amorphous silicon (a-Si) instead of the top surface of the second partition wall layer L2 including or consisting of titanium (Ti), the reflectance of external light may be reduced.

FIG. 8 is a cross-sectional view of a display panel in an embodiment of the disclosure taken along line II-II' in FIG. 5. FIG. 8 is an enlarged view of the one first light-emitting area PXA-R, the one second light-emitting area PXA-G, and the one third light-emitting area PXA-B. The description of the one light-emitting area PXA in FIG. 6 may be equally applied to each of the first to third light-emitting areas PXA-R, PXA-G, and PXA-B.

Referring to FIG. 8, the display panel DP in the illustrated embodiment may include the base layer BL, the circuit element layer DP-CL, the display element layer DP-OLED, and the thin film encapsulation layer TFE. The display element layer DP-OLED may include the light-emitting elements ED1, ED2, and ED3, sacrificial patterns SP1, SP2, and SP3, the pixel defining film PDL, the partition wall PW, and the dummy patterns DMP.

The light-emitting elements ED1, ED2, and ED3 may include the first light-emitting element ED1, the second light-emitting element ED2, and the third light-emitting element ED3. The first light-emitting element ED1 may include the first anode AE1, a first light-emitting pattern EP1, and the first cathode CE1. The second light-emitting element ED2 may include the second anode AE2, a second light-emitting pattern EP2, and the second cathode CE2. The third light-emitting element ED3 may include the third anode AE3, a third light-emitting pattern EP3, and the third cathode CE3. The first to third anodes AE1, AE2, and AE3 may be provided as a plurality of patterns. In an embodiment, the first light-emitting pattern EP1 may provide red light, the second light-emitting pattern EP2 may provide green light, and the third light-emitting pattern EP3 may provide blue light.

First to third light-emitting openings OP1-E, OP2-E, and OP3-E may be defined in the pixel defining film PDL. The first light-emitting opening OP1-E may expose at least a portion of the first anode AE1. The first light-emitting area PXA-R may be defined as an area exposed by the first light-emitting opening OP1-E of a top surface of the first anode AE1. The second light-emitting opening OP2-E may expose at least a portion of the second anode AE2. The second light-emitting area PXA-G may be defined as an area exposed by the second light-emitting opening OP2-E of a top surface of the second anode AE2. The third light-emitting opening OP3-E may expose at least a portion of the third anode AE3. The third light-emitting area PXA-B may be defined as an area exposed by the third light-emitting opening OP3-E of a top surface of the third anode AE3.

The sacrificial patterns SP1, SP2, and SP3 may include the first sacrificial pattern SP1, the second sacrificial pattern SP2, and the third sacrificial pattern SP3. Each of the first to third sacrificial patterns SP1, SP2, and SP3 may be disposed on the top surface of each of the first to third anodes AE1, AE2, and AE3. First to third sacrificial openings OP1-S, OP2-S, and OP3-S respectively corresponding to the first to third light-emitting openings OP1-E, OP2-E, and OP3-E may be defined in the first to third sacrificial patterns SP1, SP2, and SP3, respectively.

In the illustrated embodiment, first to third partition wall openings OP1-P, OP2-P, and OP3-P respectively corresponding to the first to third light-emitting openings OP1-E, OP2-E, and OP3-E may be defined in the partition wall PW. Each of the first to third partition wall openings OP1-P, OP2-P, and OP3-P may include the first area A1 (refer to FIG. 6) and the second area A2 (refer to FIG. 6) described above with reference to FIG. 6. The first partition wall layer L1 may include the first inner surfaces S-L1 (refer to FIG. 6) defining the first areas A1 of the first to third partition wall openings OP1-P, OP2-P, and OP3-P. The second partition wall layer L2 may include the second inner surfaces S-L2 (refer to FIG. 6) defining the second areas A2 of the first to third partition wall openings OP1-P, OP2-P, and OP3-P.

The first light-emitting pattern EP1 and the first cathode CE1 may be disposed in the first partition wall opening OP1-P, the second light-emitting pattern EP2 and the second cathode CE2 may be disposed in the second partition wall opening OP2-P, and the third light-emitting pattern EP3 and the third cathode CE3 may be disposed in the third partition wall opening OP3-P. The first to third cathodes CE1, CE2, and CE3 may contact the first inner surfaces S-L1 of the first partition wall layer L1, respectively.

In the illustrated embodiment, the first to third cathodes CE1, CE2, and CE3 may be physically separated from each other by the second partition wall layer L2 that forms the tip to be respectively formed within the light-emitting openings OP1-E, OP2-E, and OP3-E, and may be electrically connected to each other by being in contact with the first partition wall layer L1 to receive a common voltage. The first partition wall layer L1 may have a relatively greater electrical conductivity than the second partition wall layer L2, so that contact resistance with the first to third cathodes CE1, CE2, and CE3 may be reduced. Accordingly, a common cathode voltage may be uniformly provided to the light-emitting areas PXA-R, PXA-G, and PXA-B.

According to the disclosure, the plurality of first light-emitting patterns EP1 may be patterned and deposited in pixel units by the tip defined on the partition wall PW. That is, the first light-emitting patterns EP1 may be commonly formed using an open mask, but may be easily divided into the pixel units by the partition wall PW.

When the first light-emitting patterns EP1 are patterned using a fine metal mask ("FMM"), a support spacer protruding from the conductive partition wall needs to be provided to support the fine metal mask. In addition, as the fine metal mask is spaced apart from a base surface on which the patterning is performed by a height of the partition wall and the spacer, realization of relatively high resolution may be limited. In addition, as the fine metal mask contacts the spacer, foreign substances may remain on the spacer after the patterning process of the first light-emitting patterns EP1 or the spacer may be damaged because of the fine metal mask being punctured. Accordingly, a defective display panel may be formed.

In the illustrated embodiment, by including the partition wall PW, the physical separation between the light-emitting elements ED1, ED2, and ED3 may be easily achieved. Accordingly, current leakage, driving errors, or the like between the adjacent light-emitting areas PXA-R, PXA-G, and PXA-B may be prevented, and independent driving of each of the light-emitting elements ED1, ED2, and ED3 may become possible.

In particular, as the plurality of first light-emitting patterns EP1 are patterned without a mask in contact with the internal component of the display area DA (refer to FIG. 1B), a defect rate may be reduced, and thus, the display panel DP with improved process reliability may be provided. As the patterning is possible even when the separate support spacer protruding from the partition wall PW is not provided, the area sizes of the light-emitting areas PXA-R, PXA-G, and PXA-B may be miniaturized, so that the display panel DP that may easily achieve the relatively high resolution may be provided.

In addition, in manufacturing the large-area display panel DP, a process cost may be reduced as large-area mask manufacturing is omitted, and the manufacturing may not be affected by defects that may occur in the large-area mask, so that the display panel DP with the improved process reliability may be provided.

The description of the plurality of first light-emitting patterns EP1 may be equally applied to the plurality of second light-emitting patterns EP2 and the third light-emitting patterns EP3.

Capping patterns CP1, CP2, and CP3 may include the first capping pattern CP1, the second capping pattern CP2, and the third capping pattern CP3. The first to third capping patterns CP1, CP2, and CP3 may be respectively disposed on the first to third cathodes CE1, CE2, and CE3 and may be respectively disposed within the first to third partition wall openings OP1-P, OP2-P, and OP3-P.

The dummy patterns DMP may include the plurality of first dummy patterns D1, the plurality of second dummy patterns D2, and the plurality of third dummy patterns D3.

The first dummy patterns D1 may include first-first to first-third dummy patterns D11, D12, and D13 that respectively surround the first to third light-emitting areas PXA-R, PXA-G, and PXA-B in a plan view. The first-first to first-third dummy patterns D11, D12, and D13 may include or consist of the same material as that of the first to third light-emitting patterns EP1, EP2, and EP3 and may be formed in the same process as the first to third light-emitting patterns EP1, EP2, and EP3.

The second dummy patterns D2 may include second-first to second-third dummy patterns D21, D22, and D23 that respectively surround the first to third light-emitting areas PXA-R, PXA-G, and PXA-B in a plan view. The second-first to second-third dummy patterns D21, D22, and D23 may include or consist of the same material as that of the first to third cathodes CE1, CE2, and CE3 and may be formed in the same process as the first to third cathodes CE1, CE2, and CE3.

The third dummy patterns D3 may include third-first to third-third dummy patterns D31, D32, and D33 that respectively surround the first to third light-emitting areas PXA-R, PXA-G, and PXA-B in a plan view. The third-first to third-third dummy patterns D31, D32, and D33 may include or consist of the same material as that of the first to third capping patterns CP1, CP2, and CP3 and may be formed in the same process as the first to third capping patterns CP1, CP2, and CP3.

In the dummy patterns DMP, first to third dummy openings OP1-D, OP2-D, and OP3-D respectively corresponding to the first to third light-emitting openings OP1-E, OP2-E, and OP3-E may be defined. Each of the first to third dummy openings OP1-D, OP2-D, and OP3-D may include first to third areas AA1, AA2, and AA3 (refer to FIG. 9F) sequentially arranged in the third direction DR3. The first dummy opening OP1-D may be defined by inner surfaces of the first-first, second-first, and third-first dummy patterns D11, D21, and D31, the second dummy opening OP2-D may be defined by inner surfaces of the first-second, second-second, and third-second dummy patterns D12, D22, and D32, and the third dummy opening OP3-D may be defined by inner surfaces of the first-third, second-third, and third-third dummy patterns D13, D23, and D33.

The thin film encapsulation layer TFE may include lower encapsulation inorganic patterns LIL1, LIL2, and LIL3, the encapsulation organic film OL, and the upper encapsulation inorganic film UIL. In the illustrated embodiment, the lower encapsulation inorganic patterns LIL1, LIL2, and LIL3 may include the first lower encapsulation inorganic pattern LIL1, the second lower encapsulation inorganic pattern LIL2, and the third lower encapsulation inorganic pattern LIL3. The first to third lower encapsulation inorganic patterns LIL1, LIL2, and LIL3 may correspond to the first to third light-emitting openings OP1-E, OP2-E, and OP3-E, respectively.

The first lower encapsulation inorganic pattern LIL1 may cover the first light-emitting element ED1 and the first-first, second-first, and third-first dummy patterns D11, D21, and D31, and a portion thereof may be disposed inside the first partition wall opening OP1-P. The second lower encapsulation inorganic pattern LIL2 may cover the second light-emitting element ED2 and the first-second, second-second, and third-second dummy patterns D12, D22, and D32, and a portion thereof may be disposed inside the second partition wall opening OP2-P. The third lower encapsulation inorganic pattern LIL3 may cover the third light-emitting element ED3 and the first-third, second-third, and third-third dummy patterns D13, D23, and D33, and a portion thereof may be disposed inside the third partition wall opening OP3-P. The first to third lower encapsulation inorganic patterns LIL1, LIL2, and LIL3 may be provided in a form of patterns spaced apart from each other.

The low reflection layer LRL may be disposed to overlap the peripheral area NPXA. The low reflection layer LRL may be disposed between the partition wall PW and the dummy patterns DMP and between the partition wall PW and the encapsulation organic film OL, and may include or consist of a light absorbing material. Reflection of external light may occur from the low reflection layer LRL disposed between the partition wall PW and the encapsulation organic film OL. That is, external light may be reflected not from the top surface of the partition wall PW but from the top surface U-LRL (refer to FIG. 6) of the low reflection layer LRL, and thus the reflectance of external light may be reduced.

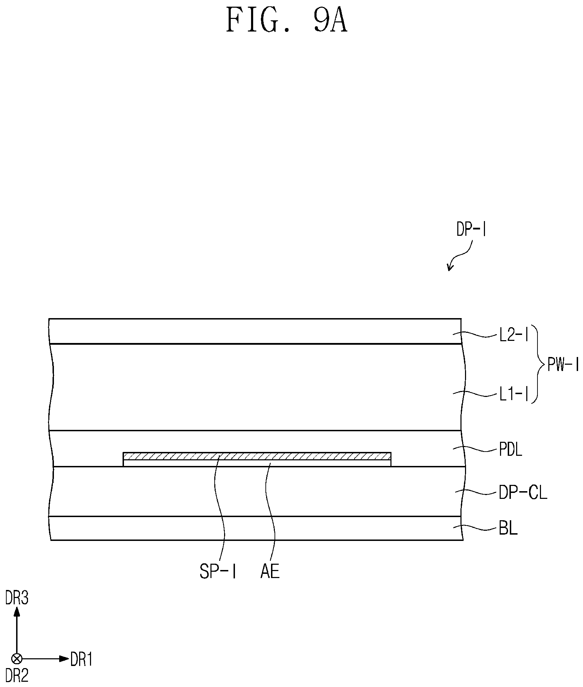

FIGS. 9A to 9I are cross-sectional views showing an embodiment of some of steps of a method for manufacturing a display panel according to the disclosure. In describing FIGS. 9A to 9I, the description will be made with reference to FIGS. 1 to 8 using the same/similar reference numerals for the same/similar components, and redundant descriptions will be omitted.

The method for manufacturing the display panel according to the disclosure may include providing a preliminary display panel including a base layer, a pixel defining film disposed on the base layer, and a preliminary partition wall disposed on the pixel defining film, forming a preliminary low reflection layer including or consisting of a light absorbing material on the preliminary partition wall, etching the preliminary low reflection layer to form a low reflection layer in which a first opening is defined, etching the preliminary partition wall to form a partition wall layer in which a partition wall opening is defined, and forming a light-emitting element including a light-emitting pattern and a cathode electrically connected to the partition wall in the partition wall opening.

Hereinafter, with reference to FIGS. 9A to 9I, a method for forming the one light-emitting element ED, the lower encapsulation inorganic pattern LIL that covers the light-emitting element ED, the encapsulation organic film OL, and the upper encapsulation inorganic film UIL will be described. A display panel formed via FIGS. 9A to 9I may correspond to the display panel DP in FIG. 6.

Referring to FIG. 9A, the method for manufacturing the display panel in the illustrated embodiment may include providing a preliminary display panel DP-I. The preliminary display panel DP-I may include the base layer BL, the circuit element layer DP-CL, the anode AE, a preliminary sacrificial pattern SP-I, the pixel defining film PDL, and a preliminary partition wall PW-I.

The circuit element layer DP-CL may be formed via the typical manufacturing process of the circuit element of forming the insulating layer, the semiconductor layer, and the conductive layer via the schemes such as the coating, deposition, or the like and may include selectively patterning the insulating layer, the semiconductor layer, and the conductive layer via the photolithography and etching processes to form the semiconductor pattern, the conductive pattern, the signal line, or the like.

The anode AE and the preliminary sacrificial pattern SP-I may be formed by the same patterning process. The pixel defining film PDL may be disposed on the base layer BL. The pixel defining film PDL may cover both the anode AE and the preliminary sacrificial pattern SP-I.

The preliminary partition wall PW-I may include a first preliminary partition wall layer L1-I and a second preliminary partition wall layer L2-I. The first preliminary partition wall layer L1-I may be disposed on the pixel defining film PDL. The second preliminary partition wall layer L2-I may be disposed on the first preliminary partition wall layer L1-I. The first and second preliminary partition wall layers L1-I and L2-I may be formed via a deposition process of a conductive material.

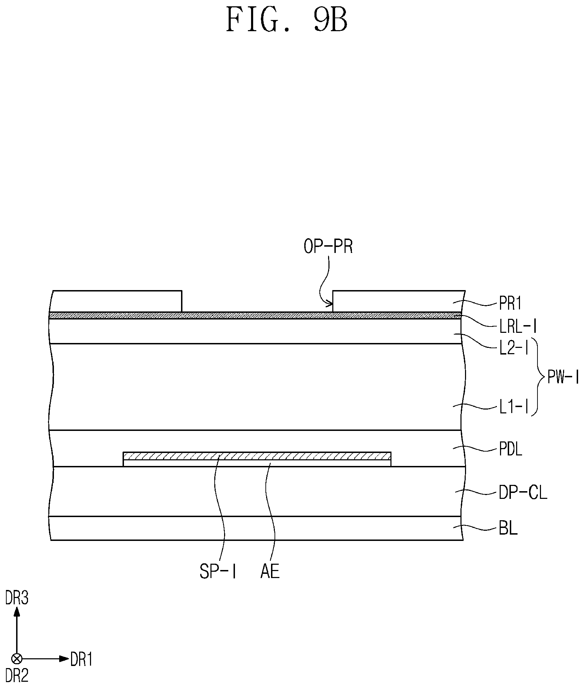

Thereafter, referring to FIG. 9B, the method for manufacturing the display panel in the illustrated embodiment may include forming a preliminary low reflection layer LRL-I and forming a first photoresist layer PR1.

The preliminary low reflection layer LRL-I may be formed on the preliminary partition wall PW-I and may include or consist of a light absorbing material. In an embodiment, the forming of the preliminary low reflection layer LRL-I may include performing chemical vapor deposition ("CVD") of a material including or consisting of amorphous silicon (a-Si) or silicon carbide (SiC). In this case, a thickness of the preliminary low reflection layer LRL-I may be equal to or greater than about 30 angstroms (Å) and equal to or smaller than about 150 angstroms (Å). In another embodiment, the forming of the preliminary low reflection layer LRL-I may include sputtering a material including or consisting of molybdenum oxide (MoOₓ). In this case, the thickness of the preliminary low reflection layer LRL-I may be equal to or greater than about 200 angstroms (Å) and equal to or smaller than about 500 angstroms (Å).

The first photoresist layer PR1 may be formed on the preliminary low reflection layer LRL-I. The first photoresist layer PR1 may be formed by forming a preliminary photoresist layer on the preliminary partition wall PW-I and then patterning the preliminary photoresist layer using a photo mask. A photo opening OP-PR overlapping the anode AE may be defined in the first photoresist layer PR1 via the patterning process.

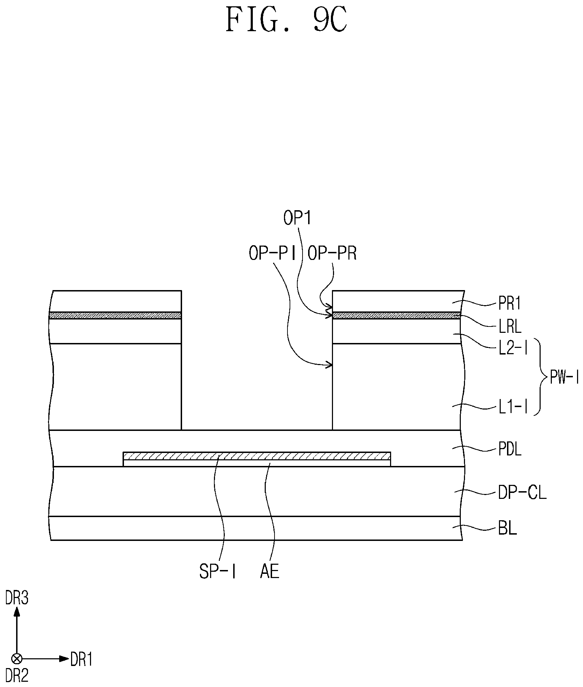

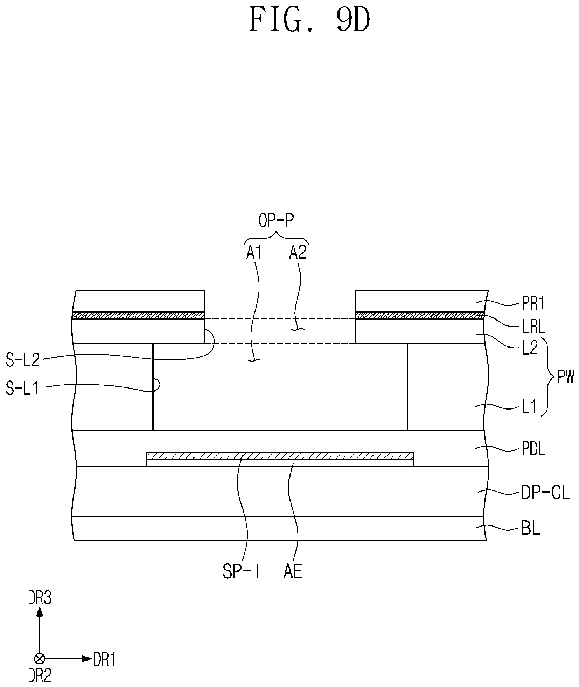

Thereafter, referring to FIGS. 9C and 9D, the method for manufacturing the display panel in the illustrated embodiment may include forming the low reflection layer LRL in which the first opening OP1 is defined by etching the preliminary low reflection layer LRL-I (refer to FIG. 9B), and forming the partition wall PW in which the partition wall opening OP-P is defined by etching the preliminary partition wall PW-I.

First, as shown in FIG. 9C, performing a primary etching on the preliminary low reflection layer LRL-I (refer to FIG. 9B), the first preliminary partition wall layer L1-I, and the second preliminary partition wall layer L2-I may include defining the first opening OP1 in the low reflection layer LRL and a preliminary partition wall opening OP-PI in the preliminary partition wall PW-I by the first photoresist layer PR1 as a mask and performing dry etching on the preliminary low reflection layer LRL-I, the first preliminary partition wall layer L1-I, and the second preliminary partition wall layer L2-I. The first opening OP1 may overlap the preliminary partition wall opening OP-PI.

The primary dry etching process in the illustrated embodiment may be performed in an etching environment in which etching selectivity of the preliminary low reflection layer LRL-I, the first preliminary partition wall layer L1-I, and the second preliminary partition wall layer L2-I are substantially the same. Accordingly, an inner surface of the low reflection layer LRL that defines the first opening OP1, an inner surface of the first preliminary partition wall layer L1-I that defines the preliminary partition wall opening OP-PI, and an inner surface of the second preliminary partition wall layer L2-I may be substantially aligned with each other.

According to the disclosure, the forming of the low reflection layer LRL by depositing the preliminary low reflection layer LRL-I and etching the preliminary low reflection layer LRL-I may be performed via batch deposition and batch etching. In an embodiment, the preliminary low reflection layer LRL-I may be deposited on the preliminary partition wall PW-I at once, instead of being deposited on the preliminary partition wall PW-I for each of the plurality of light-emitting elements, for example. In addition, the low reflection layer LRL may be formed together with the process of forming the partition wall PW by etching the preliminary partition wall PW-I without adding a separate etching process. Therefore, the manufacturing process of the display panel including the low reflection layer LRL may be simplified.

Thereafter, as shown in FIG. 9D, performing a secondary etching on the first preliminary partition wall layer L1-I may include defining the partition wall opening OP-P from the preliminary partition wall opening OP-PI (refer to 9C) by the first photoresist layer PR1 as the mask and performing a wet etching on the first preliminary partition wall layer L1-I.

The partition wall opening OP-P may include the first area A1 and the second area A2 sequentially arranged in a thickness direction (i.e., the third direction DR3). The first partition wall layer L1 may include the first inner surface S-L1 that defines the first area A1 of the partition wall opening OP-P, and the second partition wall layer L2 may include the second inner surface S-L2 that defines the second area A2.

The secondary wet etching process in the illustrated embodiment may be performed in an environment in which the etching selectivity of the first preliminary partition wall layer L1-I and the second preliminary partition wall layer L2-I are great. Accordingly, the inner surface of the partition wall PW that defines the partition wall opening OP-P may have an undercut shape in a cross-section. Specifically, as an etch rate of the first partition wall layer L1 with respect to an etching solution is greater than an etch rate of the second partition wall layer L2, the first partition wall layer L1 may be mainly etched. Accordingly, the first inner surface S-L1 of the first partition wall layer L1 may be more recessed inward than the second inner surface S-L2 of the second partition wall layer L2. A tip may be formed on the partition wall PW by a portion of the second partition wall layer L2 protruding more than the first partition wall layer L1.

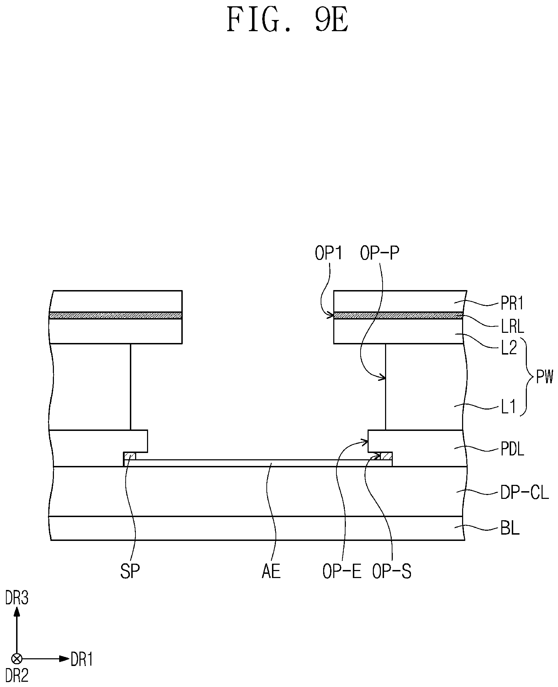

Thereafter, referring to FIG. 9E, the method for manufacturing the display panel in the illustrated embodiment may include etching the pixel defining film PDL and etching the preliminary sacrificial pattern SP-I (refer to FIG. 9D).

The etching process of the pixel defining film PDL may be performed in the dry etching scheme, and the etching may be performed using the first photoresist layer PR1, the low reflection layer LRL, and the partition wall PW (e.g., the second partition wall layer L2) as a mask. The light-emitting opening OP-E corresponding to the partition wall opening OP-P may be defined in the pixel defining film PDL.

The etching process of the preliminary sacrificial pattern SP-I may be performed in the wet etching scheme, and the etching may be performed using the first photoresist layer PR1, the low reflection layer LRL, and the partition wall PW (e.g., the second partition wall layer L2) as a mask. In the sacrificial pattern SP formed by etching the preliminary sacrificial pattern SP-I, the sacrificial opening OP-S overlapping the light-emitting opening OP-E may be defined. By the sacrificial opening OP-S and the light-emitting opening OP-E, at least a portion of the anode AE may be exposed from the sacrificial pattern SP and the pixel defining film PDL.

The etching process of the sacrificial pattern SP may be performed in an environment in which etching selectivity of the sacrificial pattern SP and the anode AE are great, and accordingly, the anode AE may be prevented from being etched together. That is, by disposing the sacrificial pattern SP having a higher etch rate than the anode AE between the pixel defining film PDL and the anode AE, the anode AE may be prevented from being etched together and damaged during the etching process.

Thereafter, referring to FIG. 9F, the method for manufacturing the display panel in the illustrated embodiment may include forming the light-emitting pattern EP in the partition wall opening OP-P after removing the first photoresist layer PR1 (refer to FIG. 9E), forming the cathode CE in contact with the first partition wall layer L1, and forming the capping pattern CP.

Each of the forming of the light-emitting pattern EP, the forming of the cathode CE, and the forming of the capping pattern CP may be performed in a deposition process. In an embodiment, the forming of the light-emitting pattern EP may be performed in a thermal evaporation process, the forming of the cathode CE may be performed in a sputtering process, and the forming of the capping pattern CP may be performed in a thermal evaporation process. However, the disclosure is not limited thereto.

The light-emitting pattern EP may be formed on the anode AE. In the forming of the light-emitting pattern EP, the light-emitting pattern EP may be separated by the tip formed on the partition wall PW and disposed within the light-emitting opening OP-E and the partition wall opening OP-P. In the forming of the light-emitting pattern EP, a first dummy layer D1-I spaced apart from the light-emitting pattern EP may be formed together on the partition wall PW.

The cathode CE may be formed on the light-emitting pattern EP. In the forming of the cathode CE, the cathode CE may be separated by the tip formed on the partition wall PW and disposed in the partition wall opening OP-P. The cathode CE may be provided with a greater incident angle than the light-emitting pattern EP, so that the cathode CE may be formed to contact the first inner surface S-L1 of the first partition wall layer L1. In the forming of the cathode CE, a second dummy layer D2-I spaced apart from the cathode CE may be formed on the partition wall PW together. The anode AE, the light-emitting pattern EP, and the cathode CE may constitute the light-emitting element ED.

The capping pattern CP may be formed on the cathode CE. In the forming of the capping pattern CP, the capping pattern CP may be separated by the tip formed on the partition wall PW and disposed in the partition wall opening OP-P. In forming of the capping pattern CP, a third dummy layer D3-I spaced apart from the capping pattern CP may be formed together on the partition wall PW. In another embodiment of the disclosure, the forming of the capping pattern CP may be omitted.

The first to third dummy layers D1-I, D2-I, and D3-I may form a dummy layer DMP-I, and the dummy opening OP-D may be defined in the dummy layer DMP-I. The dummy opening OP-D may include the first area AA1, the second area AA2, and the third area AA3 sequentially arranged in the thickness direction (i.e., the third direction DR3). The first area AA1 of the dummy opening OP-D may be defined by an inner surface of the first dummy layer D1-I, the second area AA2 may be defined by an inner surface of the second dummy layer D2-I, and the third area AA3 may be defined by an inner surface of the third dummy layer D3-I.

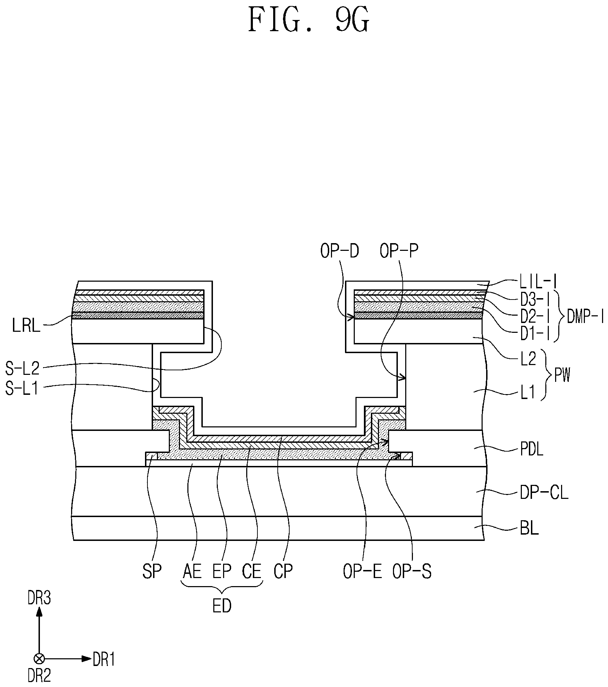

Thereafter, referring to FIG. 9G, the method for manufacturing the display panel in the illustrated embodiment may include forming a lower encapsulation inorganic layer LIL-I. The lower encapsulation inorganic layer LIL-I may be formed via a deposition process. In an embodiment, the lower encapsulation inorganic layer LIL-I may be formed via a CVD process. The lower encapsulation inorganic layer LIL-I may be formed on the partition wall PW and the cathode CE, and a portion of the lower encapsulation inorganic layer LIL-I may be formed inside the partition wall opening OP-P.

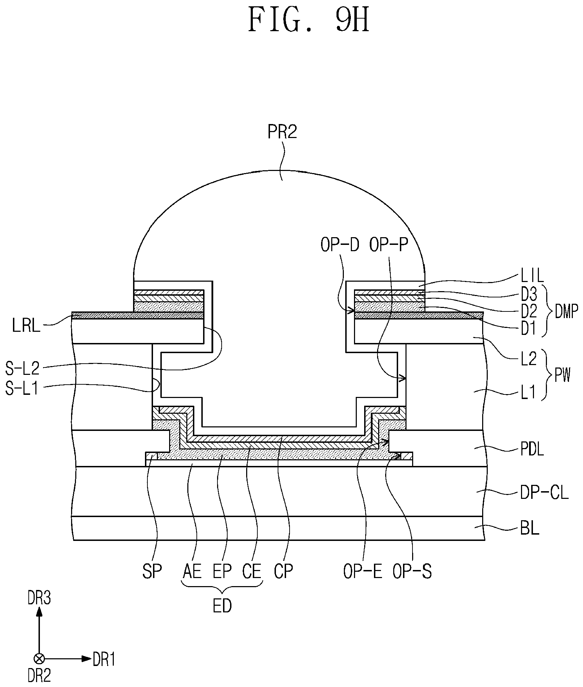

Thereafter, referring to FIG. 9H, the method for manufacturing the display panel in the illustrated embodiment may include forming a second photoresist layer PR2, patterning the lower encapsulation inorganic layer LIL-I (refer to FIG. 9G) such that the lower encapsulation inorganic pattern LIL is formed, and patterning the dummy layer DMP-I (refer to FIG. 9G) to form the dummy patterns DMP.

In the forming of the second photoresist layer PR2, the second photoresist layer PR2 may be formed by forming a preliminary photoresist layer and then patterning the preliminary photoresist layer using a photo mask. With the patterning process, the second photoresist layer PR2 may be formed in a pattern corresponding to the light-emitting opening OP-E.

In the patterning of the lower encapsulation inorganic layer LII,-I, the lower encapsulation inorganic layer LIL-I may be dry-etched to be patterned such that portions of the lower encapsulation inorganic layer LIL-I overlapping the remaining anodes excluding the corresponding anode AE are removed. The lower encapsulation inorganic pattern LIL overlapping the corresponding light-emitting opening OP-E may be formed from the patterned lower encapsulation inorganic layer LIL-I.

The patterning of the dummy layer DMP-I (refer to FIG. 9G) may include performing a dry etching on the first to third dummy layers D1-I, D2-I, and D3-I (refer to FIG. 9G) to perform the patterning such that portions of the first to third dummy layers D1-I, D2-I, and D3-I overlapping the remaining anodes excluding the corresponding anode AE may be removed. When the dummy layer DMP-I is etched, the low reflection layer LRL may not be etched because an etching solution does not affect the low reflection layer LRL.

From the patterned first to third dummy layers D1-I, D2-I, and D3-I, the first to third dummy patterns D1, D2, and D3 overlapping the corresponding light-emitting opening OP-E may be formed, so that the dummy patterns DMP including the first to third dummy patterns D1, D2, and D3 may be formed. The first to third dummy patterns D1, D2, and D3 may have a closed-line shape that surrounds the corresponding light-emitting area PXA-R, PXA-G, or PXA-B (refer to FIG. 5) in a plan view.

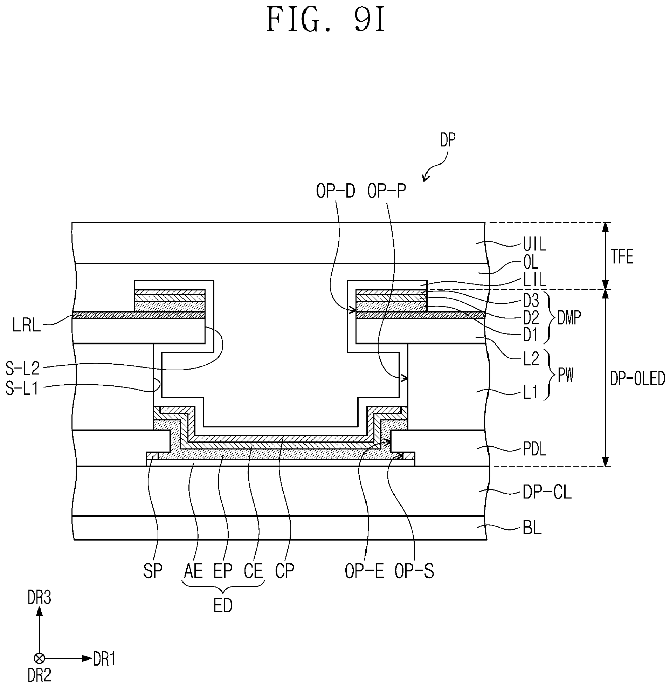

Thereafter, referring to FIG. 9I, the method for manufacturing the display panel in the illustrated embodiment may further include completing the display panel DP by removing the second photoresist layer PR2 (refer to FIG. 9H) and then forming the encapsulation organic film OL and the upper encapsulation inorganic film UIL. The encapsulation organic film OL may be formed by applying an organic material in an inkjet scheme, but the disclosure may not be limited thereto. The encapsulation organic film OL provides a planarized top surface. Thereafter, the upper encapsulation inorganic film UIL may be formed by depositing an inorganic material. Accordingly, the display panel DP including the base layer BL, the circuit element layer DP-CL, the display element layer DP-OLED, and the thin film encapsulation layer TFE may be formed.

Between the forming of the lower encapsulation inorganic pattern LIL and the completing of the display panel DP, defining a first opening, a partition wall opening, and a light-emitting opening corresponding to each of light-emitting areas of different colors in the partition wall PW and the pixel defining film PDL, forming light-emitting elements providing the different colors, and forming a lower encapsulation inorganic pattern that covers the light-emitting elements providing the different colors may further be executed. Accordingly, the display panel DP including first to third light-emitting elements, first to third capping patterns, a low reflection layer, first-first to first-third dummy patterns, second-first to second-third dummy patterns, third-first to third-third dummy patterns, and first to third lower encapsulation inorganic patterns respectively corresponding to the plurality of light-emitting areas PXA-R, PXA-G, and PXA-B shown in FIG. 5 may be formed.

Although the description has been made with reference to the preferred embodiment, those skilled in the art will understand that the disclosure may be modified and changed in various ways without departing from the scope of the disclosure described in the following claims. Therefore, the technical scope of the disclosure should not be limited to the contents described in the detailed description of the document, but should be determined by the claims.

As described above, as the display panel includes the low reflection layer disposed on the partition wall, external light may be reflected from the top surface of the low reflection layer instead of the top surface of the partition wall. Accordingly, the reflectance of external light may be reduced. The low reflection layer may not have the color resulted from the interference effect of external light.

In addition, the forming of the low reflection layer by depositing the preliminary low reflection layer and etching the preliminary low reflection layer may be executed via the batch deposition and the batch etching. In an embodiment, the preliminary low reflection layer may be deposited on the preliminary partition wall at once, instead of being deposited for each of the plurality of light-emitting elements, for example. In addition, the low reflection layer may be formed together with the process of forming the partition wall by etching the preliminary partition wall without adding the separate etching process. Therefore, the manufacturing process of the display panel including the low reflection layer may be simplified.

While the disclosure has been described with reference to embodiments thereof, it will be apparent to those of ordinary skill in the art that various changes and modifications may be made thereto without departing from the scope of the disclosure as set forth in the following claims.

## Claims

1. A display panel comprising:
a base layer;
a pixel defining film which is disposed on the base layer and in which a light-emitting opening is defined;
a partition wall which is disposed on the pixel defining film and in which a partition wall opening corresponding to the light-emitting opening is defined;
a low reflection layer disposed on the partition wall and including a light absorbing material; and
a light-emitting element including an anode, an intermediate layer, and a cathode electrically connected to the partition wall, and overlapping the partition wall opening.

2. The display panel of claim 1, further comprising:
a thin film encapsulation layer covering the partition wall and the light-emitting element,
wherein the low reflection layer contacts a portion of the thin film encapsulation layer.

3. The display panel of claim 1 or claim 2, wherein the low reflection layer includes amorphous silicon (a-Si).

4. The display panel of claim 1 or claim 2, wherein the low reflection layer includes silicon carbide (SiC).

5. The display panel of claim 1 or claim 2, wherein the low reflection layer includes molybdenum oxide (MoOₓ).

6. The display panel of any one of claims 1 to 4, wherein a thickness of the low reflection layer is equal to or greater than about 30 angstroms and equal to or smaller than about 150 angstroms.

7. The display panel of any one of claims 1, 2, or 5, wherein a thickness of the low reflection layer is equal to or greater than about 200 angstroms and equal to or smaller than about 500 angstroms.

8. The display panel of any one of claims 1 to 7, wherein the partition wall includes a first partition wall layer disposed on the pixel defining film and defining a first area of the partition wall opening, and a second partition wall layer disposed on the first partition wall layer and defining a second area of the partition wall opening.

9. The display panel of claim 8, wherein the low reflection layer includes an inner surface, the inner surface of the low reflection layer defining a first opening overlapping the partition wall opening, and the inner surface of the low reflection layer is aligned with an inner surface of the second partition wall layer.

10. A method for manufacturing a display panel, the method comprising:
providing a preliminary display panel including a base layer, a pixel defining film disposed on the base layer, and a preliminary partition wall disposed on the pixel defining film;
forming a preliminary low reflection layer including a light absorbing material on the preliminary partition wall;
forming a low reflection layer with a first opening defined by etching the preliminary low reflection layer;
forming a partition wall with a partition wall opening defined by etching the preliminary partition wall; and
forming a light-emitting element including a light-emitting pattern and a cathode electrically connected to the partition wall within the partition wall opening.

11. The method of claim 10, wherein the forming the preliminary low reflection layer includes:
performing chemical vapor deposition of a material including amorphous silicon (a-Si) or silicon carbide (SiC).

12. The method of claim 10, wherein the forming the preliminary low reflection layer includes:
sputtering a material including molybdenum oxide (MoOₓ).
